# EUROPEAN PATENT APPLICATION

(11) **EP 3 633 529 A1**
(43) Date of publication of application: **08.04.2020**
(21) Application number: 18809491.6
(22) Date of filing: 28.03.2018
(51) Int. Cl.: G06F 17/50

(54) **SYSTEMC MODEL GENERATION METHOD AND SYSTEMC MODEL GENERATION PROGRAM**

(30) Priority: 29.05.2017 JP 2017105814
(71) Applicant: Fujitsu Limited, Kawasaki-shi, Kanagawa 211-8588 (JP)
(72) Inventor: YAMASHITA, Hiroaki, fukuoka-shi Fukuoka 814-8588 (JP); IMAZATO, Kenichi, fukuoka-shi Fukuoka 814-8588 (JP); TAMIYA, Yutaka, Kawasaki-shi Kanagawa 211-8588 (JP)
(74) Representative: Hoffmann Eitle
(86) International application number: PCT/JP2018/012695
(87) International publication number: WO 2018/220974

(57) **Abstract**

It is aimed to provide a SystemC model generation method and a SystemC model generation program capable of allowing an HDL behavioral model to be used for logic circuit design.

Provided is a SystemC model generation method of generating a SystemC model SCM capable of high-level synthesis from an HDL behavioral model BM designed with an HDL simulation syntax. The SystemC model generation method includes: analyzing the HDL behavioral model to generate a syntax tree model (PA); analyzing the syntax tree model to extract analysis information (AI) (PMA01, PMA02); and reconstructing the syntax tree model based on the syntax tree model and the analysis information (PMR01, PMR02) to generate the SystemC model (PSCG).

## Description

### TECHNICAL FIELD

The present invention relates to a SystemC model generation method and a SystemC model generation program.

### BACKGROUND ART

In recent years, for example, when a logic circuit of a large-scale integrated circuit (LSI) or a field-programmable gate array (FPGA) is designed, a hardware description language (HDL) such as Verilog-HDL or VHDL is used. Moreover, the design at the register transfer level (RTL) by HDL (language) has become mainstream.

The RTL design is a design technique of converting a model (RTL model) designed with the degree of abstraction at the register transfer level using an HDL language into a netlist (gate circuit) at a gate level by a logic synthesis tool. Here, when a sequence processing circuit is designed in the HDL language, the design is performed, for example, with a structure separated into a state transition circuit (state machine) and a combinational circuit in order to make design at an RTL capable of logic synthesis.

Incidentally, conventionally, a variety of proposals has been made as a technique of RTL design in the HDL language.

### CITATION LIST

### PATENT DOCUMENT

Patent Document 1: Japanese Laid-open Patent Publication No. 2013-020329

### SUMMARY OF INVENTION

### TECHNICAL PROBLEM

As described above, the RTL design in the HDL language is, for example, designed with a structure separated into a state transition circuit and a combinational circuit; however, the RTL design of the state transition circuit has a higher degree of design difficulty because the logic is complicated, and accordingly the man-hours (time and cost) required for the design increase. Furthermore, as the design becomes more complex, defects also tend to occur.

In addition, although the behavioral model (HDL behavioral model) designed with an HDL language simulation syntax can be easily created, no logic synthesis tool for converting the behavioral model into a netlist is provided, such that conversion into a netlist using the behavioral model is difficult. Note that, in the present description, the HDL behavioral model is used as, for example, a behavioral model that does not include a SystemC model capable of high-level synthesis, but is designed with a pure HDL language simulation syntax such as Verilog-HDL or VHDL.

### SOLUTION TO PROBLEM

According to one embodiment, there is provided a SystemC model generation method of generating a SystemC model capable of high-level synthesis from an HDL behavioral model designed with an HDL simulation syntax.

The SystemC model generation method analyzes the HDL behavioral model to generate a syntax tree model, and analyzes the syntax tree model to extract analysis information. Furthermore, the SystemC model generation method reconstructs the syntax tree model based on the syntax tree model and the analysis information to generate the SystemC model.

### ADVANTAGEOUS EFFECTS OF INVENTION

The disclosed SystemC model generation method and SystemC model generation program have an effect of allowing the HDL behavioral model to be used for logic circuit design.

### BRIEF DESCRIPTION OF DRAWINGS

FIG. 1 is a diagram schematically illustrating an example of a logic circuit design technique.
FIG. 2 is a diagram (Part 1) for illustrating an example of RTL design in the logic circuit design illustrated in FIG. 1.
FIG. 3 is a diagram (Part 2) for illustrating an example of RTL design in the logic circuit design illustrated in FIG. 1.
FIG. 4 is a diagram for illustrating an example of behavioral level design.
FIG. 5 is a diagram schematically illustrating a problem in the logic circuit design technique.
FIG. 6 is a diagram schematically illustrating an example of a logic circuit design technique to which a SystemC model generation method according to the present embodiment is applied.
FIG. 7 is a flowchart for illustrating the overall configuration of the SystemC model generation method according to the present embodiment.
FIG. 8 is a flowchart (Part 1) for illustrating an example of the SystemC model generation method.
FIG. 9 is a flowchart (Part 2) for illustrating an example of the SystemC model generation method.
FIG. 10 is a diagram for illustrating respective processing contents of the flowcharts of the SystemC model generation method illustrated in FIGS. 8 and 9.
FIG. 11 is a diagram for illustrating the dependency between respective items of processing in the flowcharts of the SystemC model generation method illustrated in FIGS. 8 and 9.
FIG. 12 is a diagram (Part 1) for illustrating each item of processing in the flowcharts of the SystemC model generation method illustrated in FIGS. 8 and 9.
FIG. 13 is a diagram (Part 2) for illustrating each item of processing in the flowcharts of the SystemC model generation method illustrated in FIGS. 8 and 9.
FIG. 14 is a diagram (Part 3) for illustrating each item of processing in the flowcharts of the SystemC model generation method illustrated in FIGS. 8 and 9.
FIG. 15 is a diagram (Part 4) for illustrating each item of processing in the flowcharts of the SystemC model generation method illustrated in FIGS. 8 and 9.
FIG. 16 is a diagram (Part 5) for illustrating each item of processing in the flowcharts of the SystemC model generation method illustrated in FIGS. 8 and 9.
FIG. 17 is a diagram (Part 6) for illustrating each item of processing in the flowcharts of the SystemC model generation method illustrated in FIGS. 8 and 9.
FIG. 18 is a diagram (Part 7) for illustrating each item of processing in the flowcharts of the SystemC model generation method illustrated in FIGS. 8 and 9.
FIG. 19 is a diagram (Part 1) for illustrating an example of processing of generating a SystemC model from an HDL behavioral model by applying the SystemC model generation method illustrated in FIGS. 8 and 9.
FIG. 20 is a diagram (Part 2) for illustrating an example of processing of generating a SystemC model from an HDL behavioral model by applying the SystemC model generation method illustrated in FIGS. 8 and 9.
FIG. 21 is a diagram (Part 3) for illustrating an example of processing of generating a SystemC model from an HDL behavioral model by applying the SystemC model generation method illustrated in FIGS. 8 and 9.
FIG. 22 is a diagram (Part 4) for illustrating an example of processing of generating a SystemC model from an HDL behavioral model by applying the SystemC model generation method illustrated in FIGS. 8 and 9.
FIG. 23 is a diagram (Part 5) for illustrating an example of processing of generating a SystemC model from an HDL behavioral model by applying the SystemC model generation method illustrated in FIGS. 8 and 9.
FIG. 24 is a diagram (Part 6) for illustrating an example of processing of generating a SystemC model from an HDL behavioral model by applying the SystemC model generation method illustrated in FIGS. 8 and 9.
FIG. 25 is a diagram (Part 7) for illustrating an example of processing of generating a SystemC model from an HDL behavioral model by applying the SystemC model generation method illustrated in FIGS. 8 and 9.
FIG. 26 is a diagram (Part 8) for illustrating an example of processing of generating a SystemC model from an HDL behavioral model by applying the SystemC model generation method illustrated in FIGS. 8 and 9.
FIG. 27 is a diagram (Part 9) for illustrating an example of processing of generating a SystemC model from an HDL behavioral model by applying the SystemC model generation method illustrated in FIGS. 8 and 9.
FIG. 28 is a diagram (Part 10) for illustrating an example of processing of generating a SystemC model from an HDL behavioral model by applying the SystemC model generation method illustrated in FIGS. 8 and 9.
FIG. 29 is a diagram (Part 11) for illustrating an example of processing of generating a SystemC model from an HDL behavioral model by applying the SystemC model generation method illustrated in FIGS. 8 and 9.
FIG. 30 is a diagram (Part 12) for illustrating an example of processing of generating a SystemC model from an HDL behavioral model by applying the SystemC model generation method illustrated in FIGS. 8 and 9.
FIG. 31 is a diagram (Part 1) for illustrating another example of processing of generating a SystemC model from an HDL behavioral model by applying the SystemC model generation method illustrated in FIGS. 8 and 9.
FIG. 32 is a diagram (Part 2) for illustrating another example of processing of generating a SystemC model from an HDL behavioral model by applying the SystemC model generation method illustrated in FIGS. 8 and 9.
FIG. 33 is a diagram (Part 3) for illustrating another example of processing of generating a SystemC model from an HDL behavioral model by applying the SystemC model generation method illustrated in FIGS. 8 and 9.
FIG. 34 is a diagram (Part 4) for illustrating another example of processing of generating a SystemC model from an HDL behavioral model by applying the SystemC model generation method illustrated in FIGS. 8 and 9.
FIG. 35 is a diagram (Part 5) for illustrating another example of processing of generating a SystemC model from an HDL behavioral model by applying the SystemC model generation method illustrated in FIGS. 8 and 9.
FIG. 36 is a diagram (Part 6) for illustrating another example of processing of generating a SystemC model from an HDL behavioral model by applying the SystemC model generation method illustrated in FIGS. 8 and 9.
FIG. 37 is a diagram (Part 7) for illustrating another example of processing of generating a SystemC model from an HDL behavioral model by applying the SystemC model generation method illustrated in FIGS. 8 and 9.
FIG. 38 is a diagram (Part 8) for illustrating another example of processing of generating a SystemC model from an HDL behavioral model by applying the SystemC model generation method illustrated in FIGS. 8 and 9.

### DESCRIPTION OF EMBODIMENTS

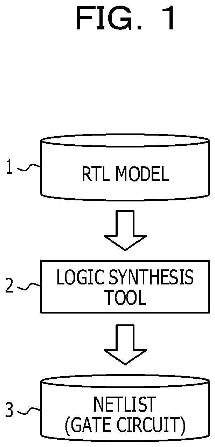

First, before a SystemC model generation method and a SystemC model generation program of the present example are described in detail, an example of a logic circuit design technique and its problems will be described with reference to FIGS. 1 to 5.

FIG. 1 is a diagram schematically illustrating an example of a logic circuit design technique. As illustrated in FIG. 1, an example of the logic circuit design technique applies, for example, a logic synthesis tool 2 to an register transfer level model (RTL model) 1 and converts the applied RTL model 1 into a netlist (gate circuit) 3.

Incidentally, at present, register transfer level design (RTL design) on the basis of a hardware description language (HDL language) such as Verilog-HDL or VHDL is mainstream in the logic circuit design for LSI or FPGA. As described above, when a sequence processing circuit is designed in the HDL language, the design is performed, for example, with a structure separated into a state machine and a combinational circuit in order to make design at an RTL capable of logic synthesis.

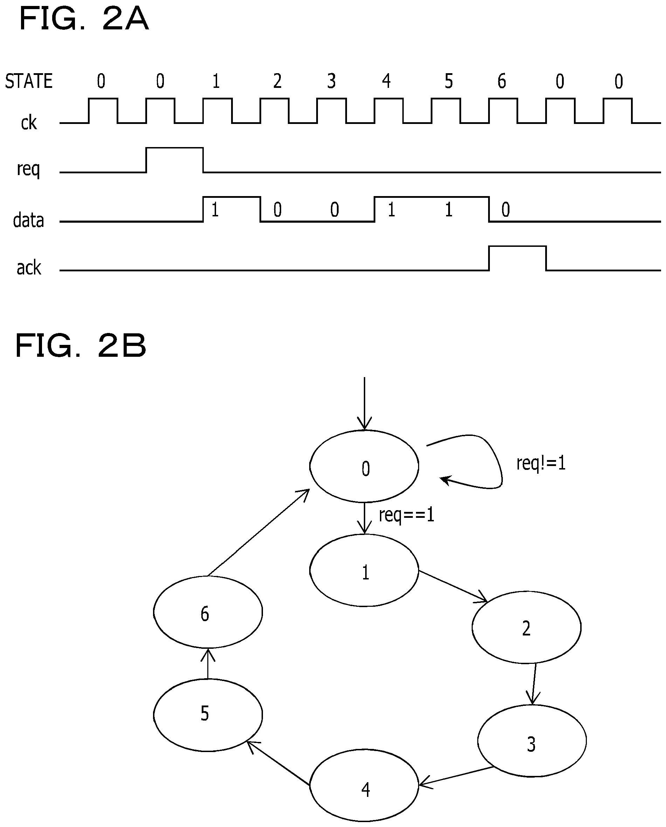

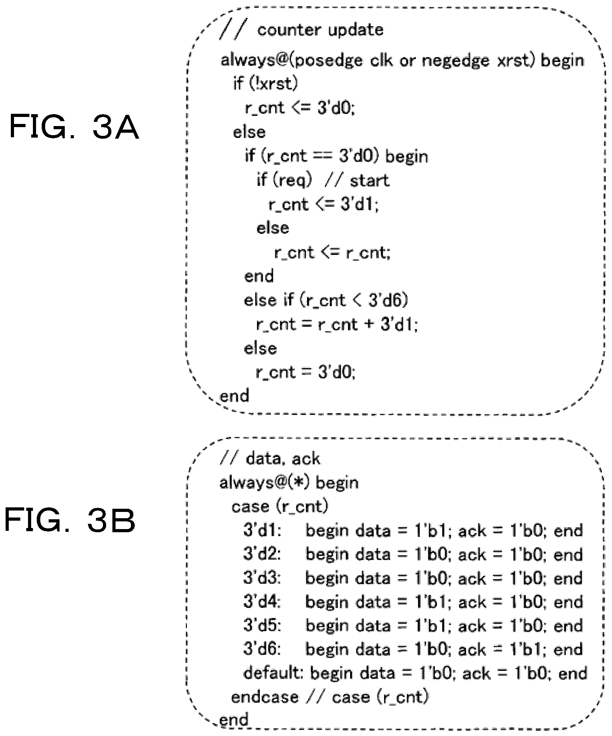

FIGS. 2 and 3 are diagrams for illustrating an example of the RTL design in the logic circuit design illustrated in FIG. 1; FIG. 2(a) illustrates an example of RTL design for sequence processing, and FIG. 2(b) illustrates a state machine. In addition, FIG. 3(a) illustrates a state machine described at the RTL, and FIG. 3(b) illustrates a combinational circuit described at the RTL. As illustrated in FIG. 2(a), in this example, once a request signal req is received, a data signal data "100110" of six clocks and an acknowledge signal ack at the end of data of the data signal data are returned.

That is, when the RTL design in FIG. 2(a) is performed, a counter in FIG. 3(a) that counts six clocks when req is received is designed with the state machine in FIG. 2(b), and a data value to be output is defined according to the value of the counter in FIG. 3(b).

However, this RTL design of the state machine has a higher degree of design difficulty because the logic is complicated, and accordingly the time and cost required for the design increases; furthermore, defects also tends to occur as the design becomes more complex. That is, when RTL design of sequence processing is performed, there are many concerns to consider, which are bothersome and also difficult to interpret, and there is thus a problem that it is easy to make mistakes and it is difficult to make modifications.

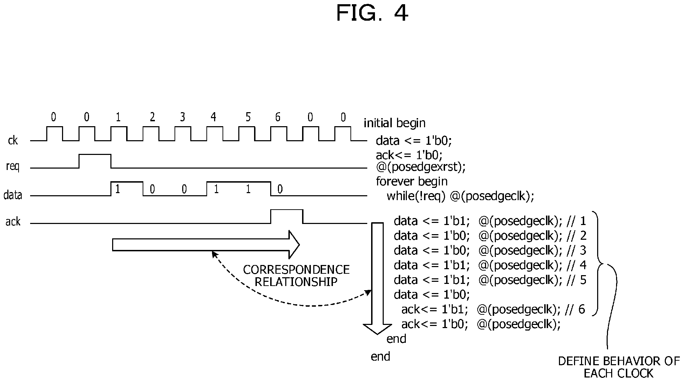

FIG. 4 is a diagram for illustrating an example of behavioral level design; FIG. 4(a) is similar to FIG. 2(a) described above, and FIG. 4(b) illustrates an example of behavioral model design of sequence processing. For example, as illustrated in FIG. 4(b), since it is sufficient to define the behavior of each clock based on a time chart (behavior specifications) illustrated in FIG. 4(a), the behavioral model design for an HDL behavioral model or the like has the advantages of being simple, easy to interpret, difficult to make mistakes, and easy to make modifications. That is, the behavioral level design can easily create a sequence control circuit.

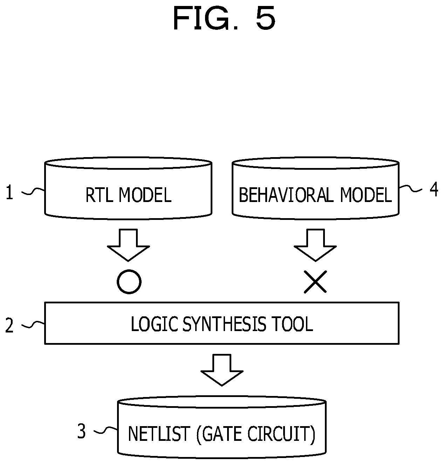

FIG. 5 is a diagram schematically illustrating a problem in the logic circuit design technique. As illustrated in FIG. 5, the RTL model 1 can be converted into the netlist 3 by applying the logic synthesis tool 2. However, the logic synthesis tool 2 does not support, for example, an HDL language simulation syntax, and it has thus been difficult to perform logic synthesis on a behavioral model 4 designed with the HDL language simulation syntax, even though the behavioral model 4 behaves on a logic simulator. That is, there is a problem that it is difficult to convert the behavioral model 4 into the netlist 3 by applying the logic synthesis tool 2.

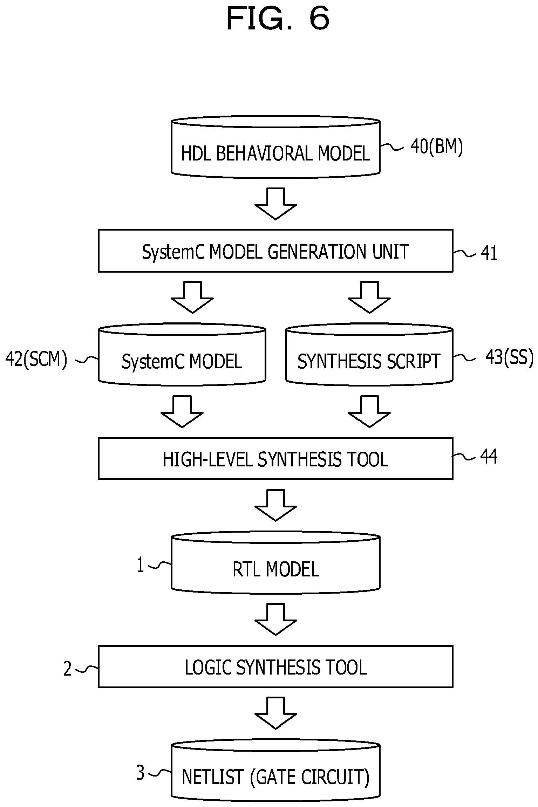

Hereinafter, an example of the SystemC model generation method and the SystemC model generation program will be described in detail with reference to the attached drawings. FIG. 6 is a diagram schematically illustrating an example of a logic circuit design technique to which the SystemC model generation method according to the present embodiment is applied.

As is clear from the comparison between FIG. 6 and FIG. 1 described above, the SystemC model generation method and the SystemC model generation program of the present embodiment support a SystemC model generation unit 41 in FIG. 6. That is, the SystemC model generation unit 41 generates (converts) a SystemC model (SCM) 42 from an HDL behavioral model (BM) 40. Furthermore, the SystemC model generation unit 41 may generate a synthesis script 43 (SS). Then, the RTL model 1 is generated by applying a high-level synthesis tool 44 to the SystemC model 42 and the synthesis script 43. Note that this generated RTL model 1 can be converted (generated) into the netlist 3 by applying the logic synthesis tool 2 as in FIG. 1 described above. That is, according to the SystemC model generation method and the SystemC model generation program of the present embodiment, it becomes possible to use the HDL behavioral model for logic circuit design.

Here, the SystemC is already provided and used, and is for performing high-level synthesis design in a language based on the C/C⁺⁺ language. This SystemC is a description language in which, for example, behavioral level modeling and the like are closer to the system than that in Verilog-HDL and VHDL, which are pure HDLs.

The SystemC model generation method of the present embodiment is for converting (generating) a behavioral model designed with an HDL syntax for simulation into a high-level synthesizable SystemC model. Then, for example, owing to the conversion into the RTL by high-level synthesis, it becomes possible to convert a behavioral model designed with an HDL language simulation syntax into a netlist and utilize the converted netlist for logic circuit design. Note that it goes without saying that the present embodiment can also be provided as the SystemC model generation program to be executed on an operating system (OS) of a computer, such as Linux (registered trademark) or Windows (registered trademark).

Then, according to the SystemC model generation method and the SystemC model generation program of the present embodiment, a behavioral model designed with an HDL language simulation syntax can be used for the design of logic synthesis. As a result, a sequence control processing circuit can be designed straightforwardly and easily in the behavioral model using a simulation syntax. Moreover, for example, design man-hours (design time period and cost) can be decreased and defects or implementation risk or the like can be reduced as compared to RTL design.

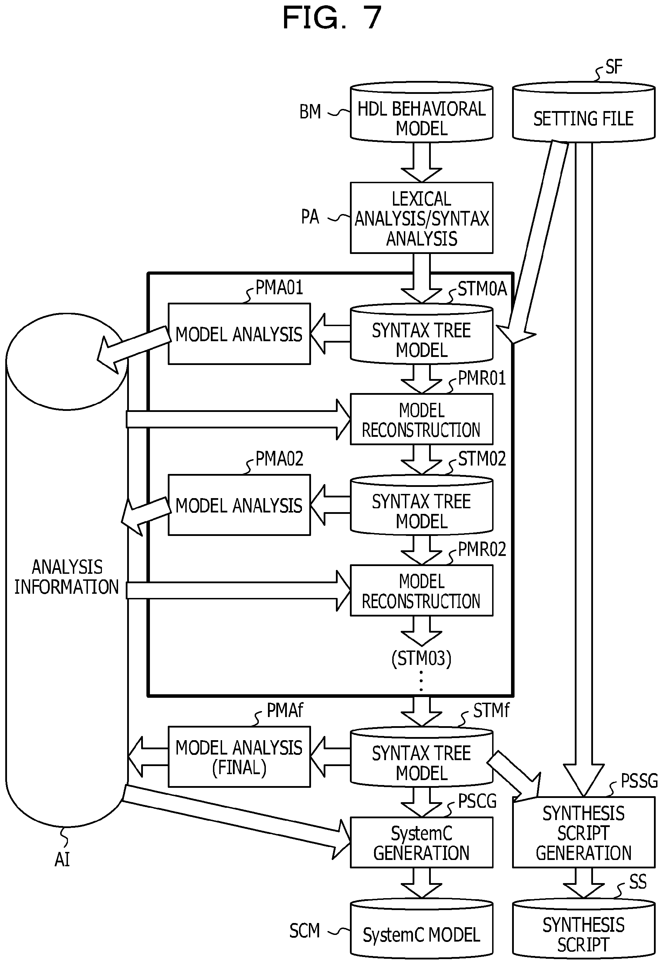

FIG. 7 is a flowchart for illustrating the overall configuration of the SystemC model generation method according to the present embodiment. In FIG. 7, reference sign BM indicates an HDL behavioral model, reference sign SF indicates a setting file, reference sign AI indicates analysis information, reference sign SCM indicates a SystemC model, and reference sign SS indicates a synthesis script. The HDL behavioral model BM, the setting file SF, the analysis information AI, the SystemC model SCM, and the synthesis script SS mentioned above are stored and held, for example, in a memory such as a dynamic random access memory (DRAM).

Here, the HDL behavioral model BM is a behavioral model designed with an HDL language simulation syntax such as Verilog-HDL or VHDL. Furthermore, the SystemC model SCM allows, for example, high-level synthesis which generates an RTL (performs conversion into an RTL model) capable of logic synthesis by applying a high-level synthesis tool. Note that, as described with reference to FIGS. 6 and 1, the RTL model (1) can be converted into the netlist (3) by applying the logic synthesis tool (2). In addition, as described above, the HDL behavioral model BM represents, for example, a behavioral model that does not include a SystemC model capable of high-level synthesis, but is designed with a pure HDL language simulation syntax such as Verilog-HDL or VHDL.

As illustrated in FIG. 7, the SystemC model generation method of the present embodiment analyzes the HDL behavioral model BM to generate a syntax tree model STM01 (PA), and further analyzes the syntax tree models STM01 and STM02 to extract analysis information AI (PMA01, PMA02). Here, processing PA of analyzing the HDL behavioral model BM to generate the syntax tree model STM01 is performed by analyzing the lexical and syntax of the HDL behavioral model BM.

Then, the syntax tree models are reconstructed based on the syntax tree models STM01 and STM02 and the analysis information AI (PMR01, PMR02), and the reconstructed syntax tree models STM02 and STM03 are generated. This syntax tree model reconstruction processing (PMR01, PMR02) based on the syntax tree model and the analysis information is performed multiple times as necessary, and a final syntax tree model (finalized syntax tree model) STMf is generated.

The syntax tree model reconstruction processing PMR01, PMR02, ... extracts different pieces of analysis information AI from the syntax tree models STM01, STM02, ... according to the order based on the dependency between respective items of processing, and performs different types of reconstruction of the syntax tree models based on the extracted different pieces of analysis information. That is, since the syntax tree model (model) reconstruction processing has a dependency with each processing, model analysis processing and model reconstruction processing of different contents are carried out in the order of processing in consideration of the dependency.

Then, the finalized syntax tree model STMf is generated, and final model analysis is performed (PMAf) to acquire final analysis information such that SystemC (code) is generated using the acquired final analysis information (PSCG), and the SystemC model SCM is generated. The final model analysis processing PMAf is a preliminary examination of information necessary for SystemC code generation and, for example, a description having a difficulty at the time of high-level synthesis is checked.

Note that the setting file SF includes a variety of types of data such as a clock signal, a reset signal, and a memory designation, and the data of the setting file SF is not only used in the syntax tree model reconstruction processing PMR01, PMR02, and the like, but also used in generation processing PSSG for the synthesis script SS. That is, the generation processing PSSG for the synthesis script generates the synthesis script SS based on information on the finalized syntax tree model STMf and information (a variety of types of data) from the setting file SF. Note that the RTL model (1) is generated by applying the high-level synthesis tool 44 to the SystemC model SCM (42) and the synthesis script SS (43) as described with reference to FIG. 6.

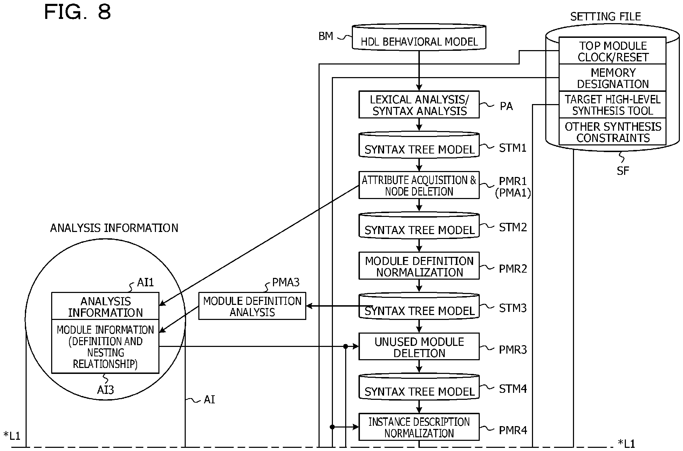

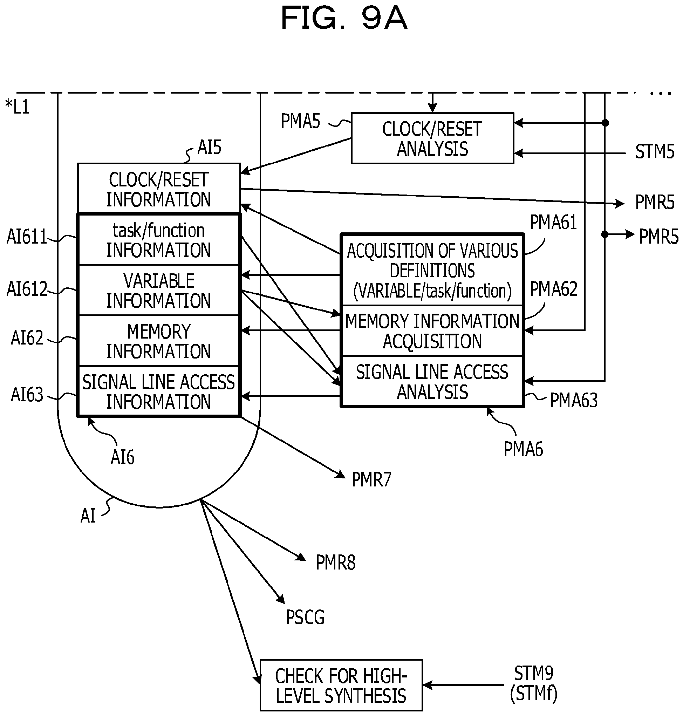

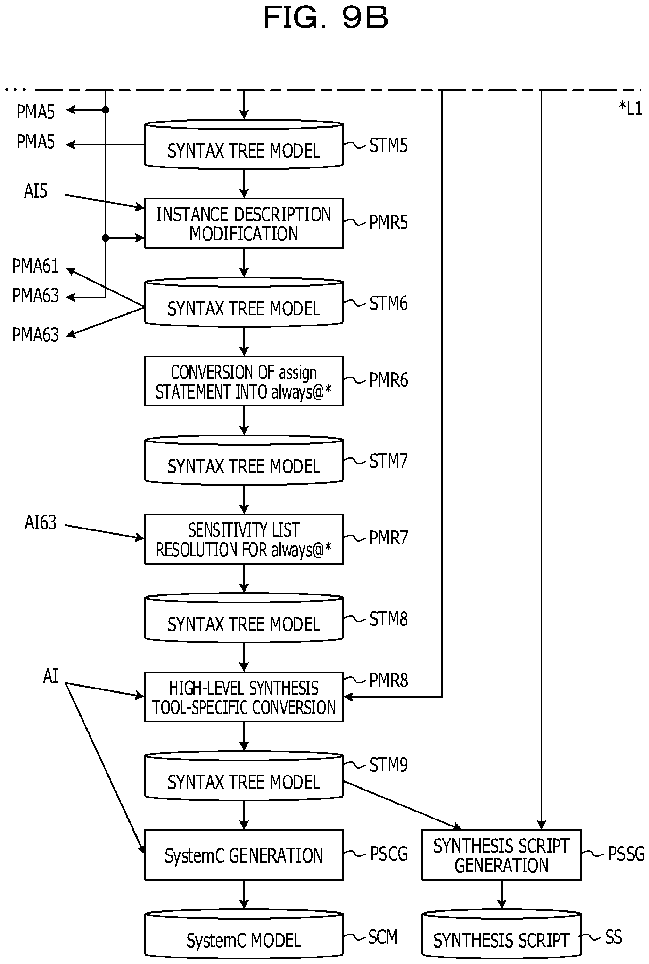

FIGS. 8 and 9 are flowcharts for illustrating one example of the SystemC model generation method, and are for illustrating in more detail one example of the SystemC model generation method illustrated in FIG. 7 described above.

First, in the setting file SF, for example, a user sets information as described below. That is, the information (data) of the setting file SF includes, for example, input source file, top module name, top module clock information, top module reset information, target high-level synthesis tool, and synthesis constraints in high-level synthesis. Here, the top module clock information includes port name, behavioral edge, and the like, and the top module reset information includes port name, information as to whether reset is synchronous or asynchronous, polarity, and the like. In addition, synthesis constraints in high-level synthesis include designation of memory and other constraints (for example, clock cycle).

Next, the analysis information AI includes attribute information AI1, module information (definition and nesting relationship) AI3, clock/reset information AI5, and task/function information AI611. Furthermore, the analysis information AI includes variable information AI612, memory information AI62, and signal line access information AI63.

The attribute information AI1 can be formed, for example, as a table storing information such as an attribute name, a value, and an application target, for each attribute description. In addition, the module information AI3 can be formed, for example, as a table storing information such as a module name, port information, parameter information, an internally instantiated module, and a node in an abstract syntax tree, for each module.

The clock/reset information AI5 can be formed, for example, as a table storing information such as a module name, a clock signal name, and a reset signal name, for each module. Furthermore, the task/function information AI611 can be formed, for example, as a table storing information on a defined module, a name, an argument, and a return value, and information such as a node in an abstract syntax tree, for each task/function.

The variable information AI612 can be formed, for example, as a table storing information such as a defined scope, a variable name, classification, and type information, for each variable. Here, the classification represents, for example, one of an output (output), an input (input), a register (reg), and a wire (wire). In addition, the type information includes, for example, the presence/absence of a sign, a bit width, the number of dimensions of an array, and the number of elements in each dimension of the array.

The memory information AI62 can be formed, for example, as a table storing information on a defined scope, a variable name, and a memory configuration, for a variable to serve as a memory. Here, the memory configuration includes the number of ports, latency, and the like of the memory. Then, the signal line access information AI63 can be formed, for example, as a table storing information on a defined module name, a process name, the name of a signal line being written, and the name of a signal line being read, for each process.

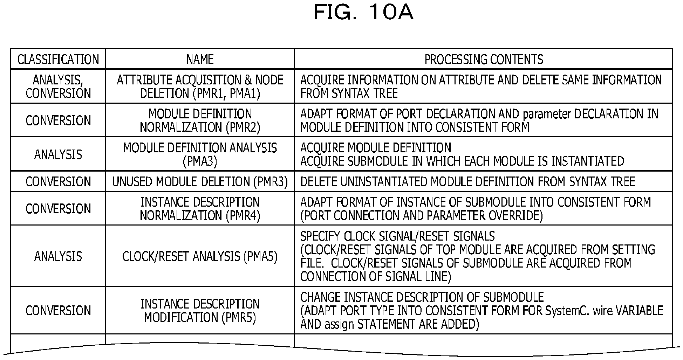

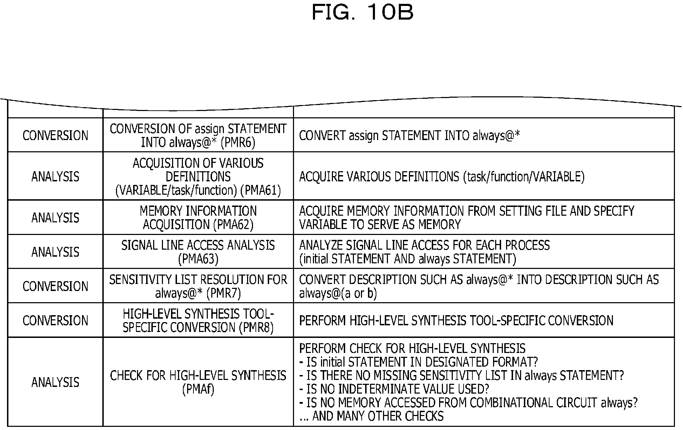

FIG. 10 is a diagram for illustrating respective processing contents of the flowcharts of the SystemC model generation method illustrated in FIGS. 8 and 9. As illustrated in FIG. 10, attribute acquisition & node deletion processing PMR1 (PMA1) acquires information on an attribute and deletes the same information from the syntax tree. Module definition normalization processing PMR2 adapts the format of a port declaration and the format of a parameter declaration in a module definition into a consistent form, and module definition analysis processing PMA3 acquires the module definition and acquires a submodule in which each module is instantiated.

Unused module deletion processing PMR3 deletes an uninstantiated module definition from the syntax tree, and instance description normalization processing PMR4 adapts the format of an instance of a submodule into a consistent form (port connection, parameter override, and the like). In addition, clock/reset analysis processing PMA5 specifies the clock signal and the reset signal. Here, the clock and reset signals of the top module are acquired from the setting file SF, and the clock and reset signals of the submodule are acquired from the connection of the signal line.

Furthermore, instance description modification processing PMR5 changes the instance description of the submodule (adapts the port type into a consistent form for SystemC and, for example, adds a wire variable and an assign statement). Processing PMR6 of converting the assign statement into always@* converts the assign statement into always@*, and acquisition processing PMA61 for various definitions (variable/task/function) acquires various definitions (variable/task/function).

In addition, memory information acquisition processing PMA62 acquires the memory information from the setting file SF and specifies a variable to serve as a memory, and signal line access analysis processing PMA63 analyzes signal line access for each process (an initial statement and an always statement). Furthermore, sensitivity list resolution processing PMR7 for always@* converts, for example, a description such as always@* into a description such as always@(a or b).

Then, high-level synthesis tool-specific conversion processing PMR8 performs high-level synthesis tool-specific conversion, and check processing PMAf for high-level synthesis performs a check for high-level synthesis. Here, checks for high-level synthesis include a variety of checks such as whether the initial statement is in a designated format, whether there is no missing sensitivity list in the always statement, whether no indeterminate value is used, and whether no memory is accessed from a combinational circuit always.

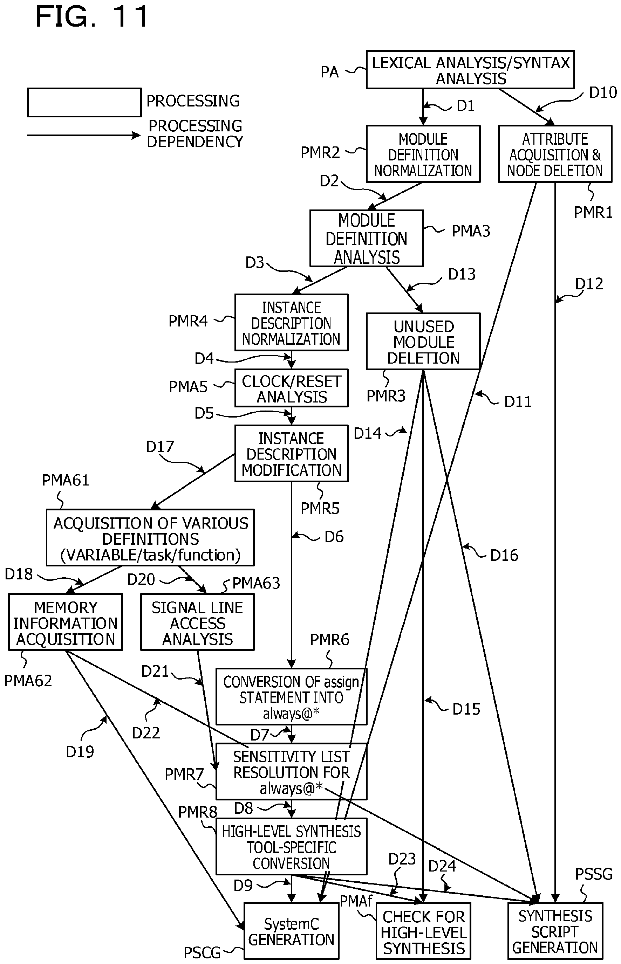

FIG. 11 is a diagram for illustrating the dependency between respective items of processing in the flowcharts of the SystemC model generation method illustrated in FIGS. 8 and 9. In FIG. 11, each block indicates each processing in FIGS. 8 and 9, and connection lines (straight lines with arrows) D1 to D24 connecting respective blocks indicate the dependency in each processing.

As indicated by the connection line D1, the module definition normalization processing PMR2 makes an operation on the syntax tree, and thus depends on the syntax tree model generation (lexical analysis/syntax analysis) processing PA. Similarly, as indicated by D10, the attribute acquisition & node deletion processing PMR1 also depends on the lexical analysis/syntax analysis processing PA, because the attribute acquisition & node deletion processing PMR1 makes an operation on the syntax tree. In addition, as indicated by D2, the module definition analysis processing PMA3 depends on the module definition normalization processing PMR2, because analysis is easier if the module definition is unified into one format. Furthermore, as indicated by D3, the instance description normalization processing PMR4 refers to module definition information when converting a connection by order into a connection by name, and thus depends on the module definition analysis processing PMA3. In addition, as indicated by D4, the clock/reset analysis processing PMA5 depends on the instance description normalization processing PMR4, because analysis is easier if the connection destination is in a definite format (connection by name) when inspecting the connection relationship of the clock signal/reset signal.

Next, as indicated by D5, the instance description modification processing PMR5 modifies the instance description such that the connection of the clock signal/reset signal is connected in a different manner from another connection (for example, connection not via wire), and thus depends on the clock/reset analysis processing PMA5. Similarly, as indicated by D6, the processing PMR6 of converting the assign statement into always@* depends on the instance description modification processing PMR5, because the assign statement is added in the modification of the instance description.

Furthermore, as indicated by D17, the acquisition processing PMA61 for various definitions depends on the instance description modification processing PMR5, because write is added in the modification of the instance description. In addition, as indicated by D18, the memory information acquisition processing PMA62 uses information on a variable to specify which variable serves as a memory, and thus depends on the acquisition processing PMA61 for various definitions. Similarly, as indicated by D20, the signal line access analysis processing PMA63 uses information on a variable and information on a called task/function to analyze which signal line each process is accessing, and thus depends on the acquisition processing PMA61 for various definitions.

Additionally, as indicated by D7, the sensitivity list resolution processing PMR7 for always@* depends on the processing PMR6 of converting the assign statement into always@* and, as indicated by D21, also depends on the signal line access analysis processing PMA63, because an always statement is added. That is, since the sensitivity list resolution processing PMR7 for always@* uses information as to which signal line each process is accessing when deriving a sensitivity list, the sensitivity list resolution processing PMR7 for always@* depends on not only the processing PMR6 of converting the assign statement into always@*, but also the signal line access analysis processing PMA63.

Furthermore, as indicated by D8, the high-level synthesis tool-specific conversion processing PMR8 preferably depends on the sensitivity list resolution processing PMR7 for always@*, because it is desirable to carry out high-level synthesis tool-specific conversion with the final syntax tree model. For example, if the processing of PMR8 is carried out on a syntax tree undergoing a series of conversions, there is a possibility that the syntax tree converted by a high-level synthesis tool will be converted into an incompatible form along the way, or the syntax tree will be converted into such a syntax tree that requires conversion for the high-level synthesis tool in a conversion along the way. That is, the connection line D8 does not mean that the high-level synthesis tool-specific conversion processing PMR8 needs derivation of the sensitivity list by the sensitivity list resolution processing PMR7 for always@*, but means that all conversions other than this processing (conversion) are required to be completed.

Then, as indicated by D19, the SystemC generation processing PSCG depends on the memory information acquisition processing PMA62, because the code generated by the SystemC differs between a variable to serve as a memory and a variable to serve as a signal line. In addition, as indicated by D13, the unused module deletion processing PMR3 refers to the module definition information when specifying an unused module, and thus depends on the module definition analysis processing PMA3. Furthermore, as indicated by D9, the SystemC generation processing PSCG also depends on the high-level synthesis tool-specific conversion processing PMR8, because it is desirable to generate SystemC for a product for which all conversions have been completed. As indicated by D14, the SystemC generation processing PSCG further depends on the unused module deletion processing PMR3, because unused modules are not included in SystemC (code). Additionally, as indicated by D11, the SystemC generation processing PSCG uses the attribute information in SystemC generation, and thus depends also on the attribute acquisition & node deletion processing PMR1. That is, the SystemC generation processing PSCG depends on four items of processing, namely, the memory information acquisition processing PMA62, the high-level synthesis tool-specific conversion processing PMR8, the unused module deletion processing PMR3, and the attribute acquisition & node deletion processing PMR1.

In addition, as indicated by D23, the check processing PMAf for high-level synthesis depends on the high-level synthesis tool-specific conversion processing PMR8, because it is desirable to finally ascertain whether high-level synthesis is allowed, for a product for which all conversions have been completed. Furthermore, as indicated by D15, the check processing PMAf for high-level synthesis also depends on the unused module deletion processing PMR3, because a check for high-level synthesis is unnecessary for an unused module. That is, the check processing PMAf for high-level synthesis depends on two items of processing, namely, the high-level synthesis tool-specific conversion processing PMR8 and the unused module deletion processing PMR3.

Then, as indicated by D24, the synthesis script generation processing PSSG depends on the high-level synthesis tool-specific conversion processing PMR8, because it is desirable to generate a synthesis script for a product for which all conversions have been completed. Furthermore, as indicated by D16, the synthesis script generation processing PSSG also depends on the unused module deletion processing PMR3, because the generation of a high-level synthesis script is unnecessary for an unused module. In addition, as indicated by D22, the synthesis script generation processing PSSG uses the memory information to generate memory synthesis constraints, and thus depends also on the memory information acquisition processing PMA62. Then, as indicated by D12, the synthesis script generation processing PSSG uses the attribute information in the generation of the synthesis script, and thus depends also on the attribute acquisition & node deletion processing PMR1. That is, the synthesis script generation processing PSSG depends on four items of processing, namely, the high-level synthesis tool-specific conversion processing PMR8, the unused module deletion processing PMR3, the memory information acquisition processing PMA62, and the attribute acquisition & node deletion processing PMR1.

As described above, in the SystemC model generation method of the present embodiment, the respective items of processing are mutually dependent; therefore, it is required to perform processing (conversion) in consideration of this dependency between the respective items of processing. That is, a variety of items of processing for reconstructing the syntax tree model based on the syntax tree model and the analysis information extract different pieces of analysis information from the syntax tree models according to the order based on the dependency between respective items of processing, and perform different types of reconstruction of the syntax tree models based on the extracted different pieces of analysis information. Then, the final syntax tree model (finalized syntax tree model) is generated, and the SystemC model SCM and the synthesis script SS are generated.

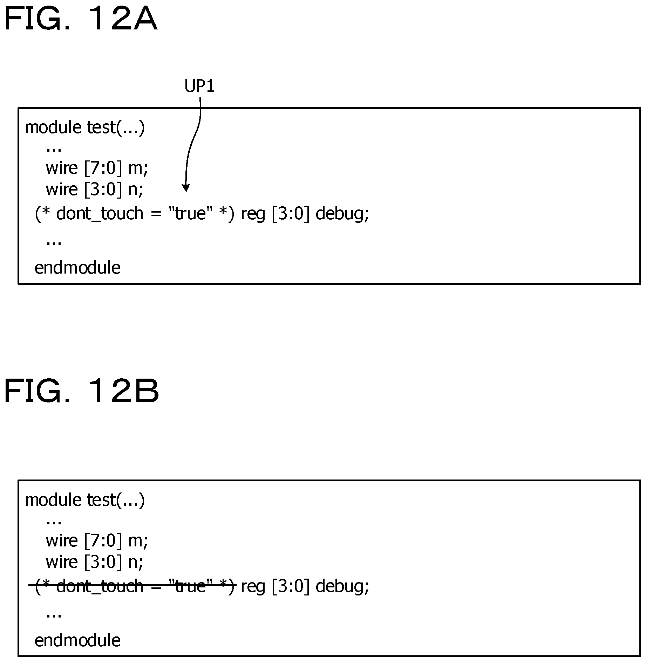

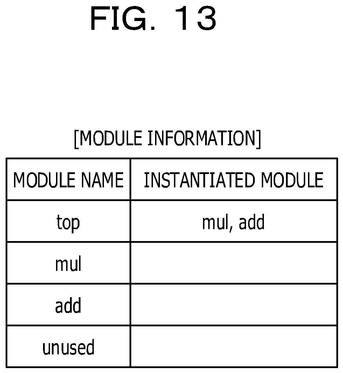

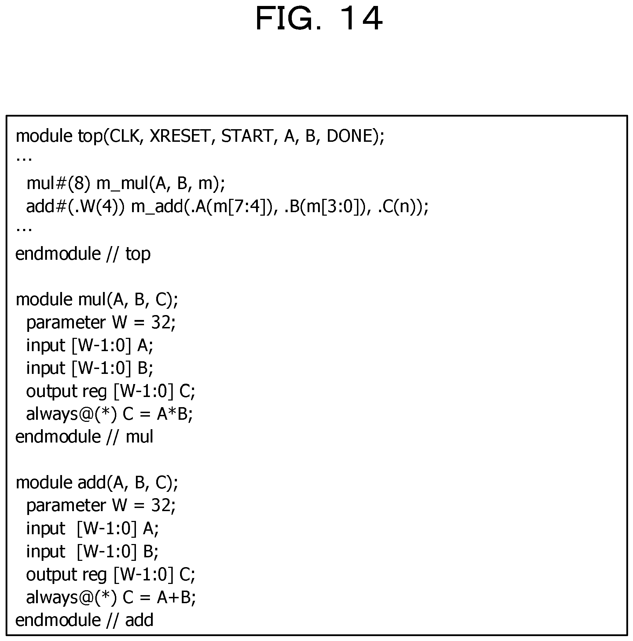

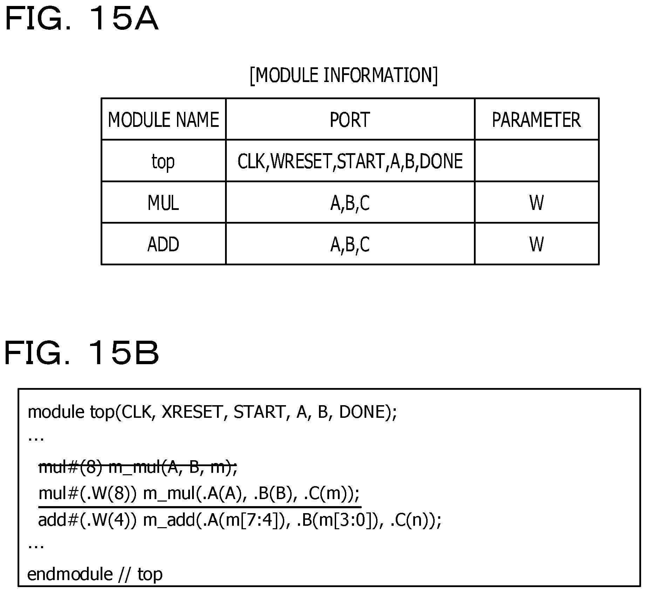

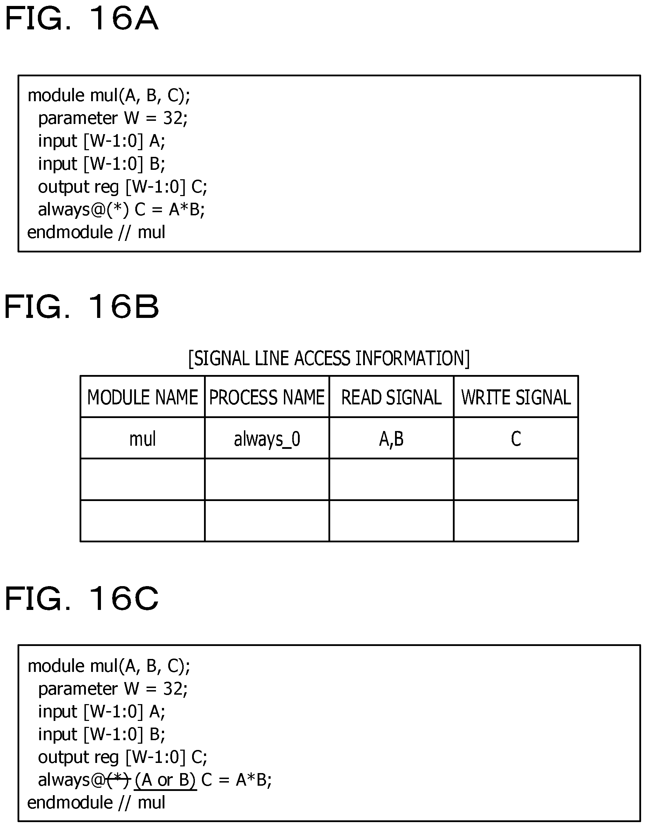

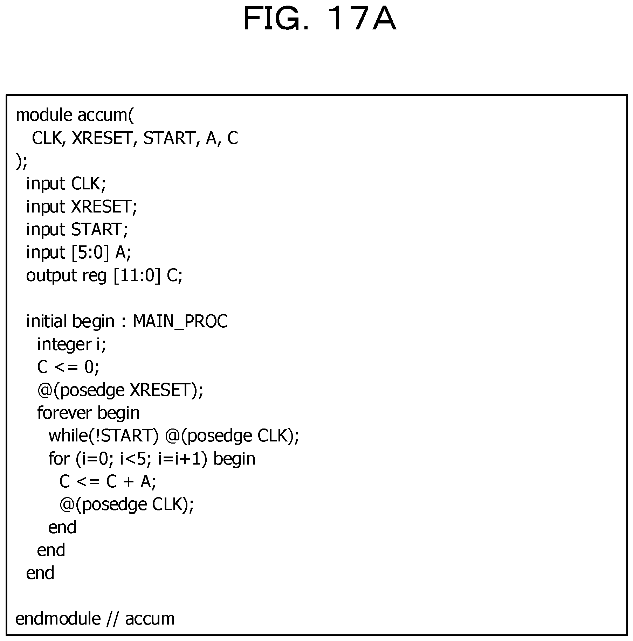

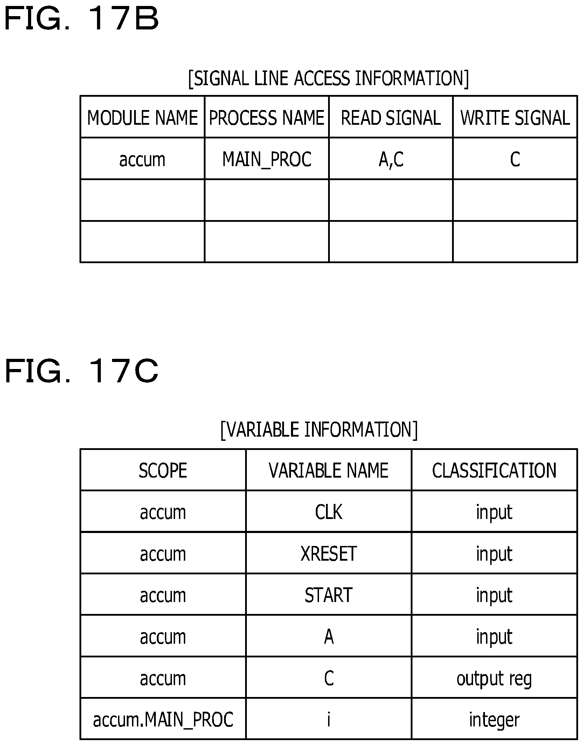

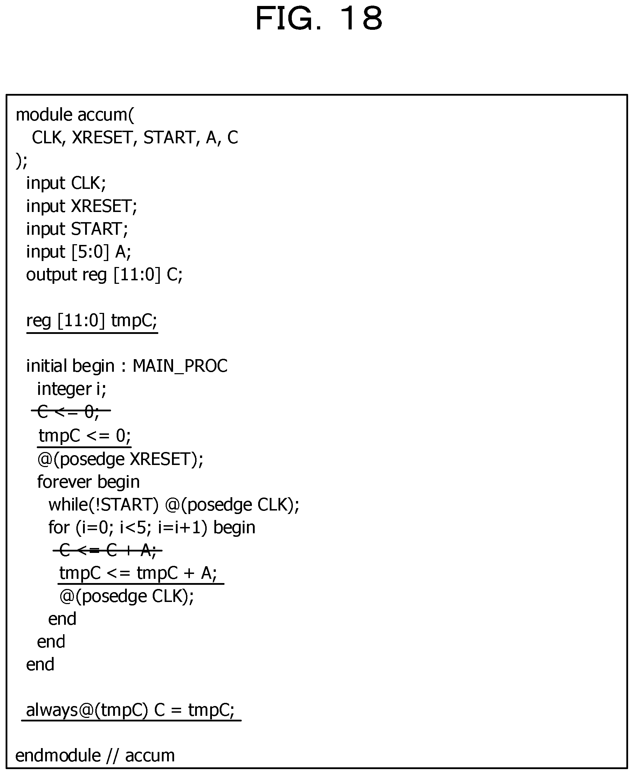

FIGS. 12 to 18 are diagrams for illustrating each item of processing of the flowcharts of the SystemC model generation method illustrated in FIGS. 8 and 9. Here, FIG. 12 is for illustrating deletion of attribute (attribute acquisition & node deletion processing PMR1 (PMA1)), and FIG. 13 is for illustrating the unused module deletion processing PMR3. In addition, FIGS. 14 and 15 are for illustrating the instance description normalization processing PMR4, and FIG. 16 is for illustrating the sensitivity list resolution processing PMR7 for always@*. Then, FIGS. 17 and 18 are for illustrating the high-level synthesis tool-specific conversion processing PMR8.

In the flowcharts of the SystemC model generation method illustrated in FIGS. 8 and 9, first, the lexical analysis/syntax analysis processing PA analyzes the lexical and syntax for an input source (HDL behavioral model BM), and generates an abstract syntax tree model (syntax tree model STM1). Next, the attribute acquisition & node deletion processing PMR1 (PMA1) will be described with reference to FIG. 12. Here, FIG. 12(a) illustrates an example of how to scan an abstract syntax tree to find a point where an attribute is used, and FIG. 12(b) illustrates an example of how to delete an attribute.

As illustrated in FIG. 12(a), the abstract syntax tree (syntax tree model STM1) is scanned to detect a point UP1 where an attribute is used, and information on the attribute is added to a table (attribute information AI1). In the example illustrated in FIG. 12(a), the attribute information added to the attribute information AI1 is, for example, as follows.
Attribute name: dont_touch
Value: "true"
Application target: test.debug

In addition, as illustrated in FIG. 12(b), the node of the attribute is deleted from the syntax tree model (abstract syntax tree) STM1 (model reconstruction), and the syntax tree model STM2 is generated. Note that, in each of FIG. 12(a) and the subsequent drawings, the deleted portion is indicated by a strike-out line, and the added portion is indicated by an underline.

While Verilog-HDL has multiple description methods for the module definition in regard to items of, for example, port declaration and parameter declaration, the module definition normalization processing PMR2 unifies the expressions on the syntax tree model into one format. That is, the module definition normalization processing PMR2 is performed on the syntax tree model STM2 to generate a syntax tree model STM3. Next, the module definition analysis processing PMA3 scans the syntax tree model STM3 to acquire the module information, and adds the acquired module information to a table (module information AI3).

The unused module deletion processing PMR3 deletes an uninstantiated module definition from the syntax tree model STM3 to generate (reconstruct) a syntax tree model STM4, and is performed, for example, according to the following procedure.
(1) Acquire the top module name from the setting file SF.
(2) Use the module information to enumerate all modules instantiated from the top module. Here, the modules to be enumerated include, for example, modules instantiated indirectly. Note that a module instantiated indirectly refers to a module instantiated in a module instantiated from the top module, or a module further instantiated from the above-mentioned module, or the like.
(3) Pick out a module registered in the module information but not included in the modules enumerated in (2) as an unused module.
(4) Delete the definition of the unused module from the syntax tree model STM3.

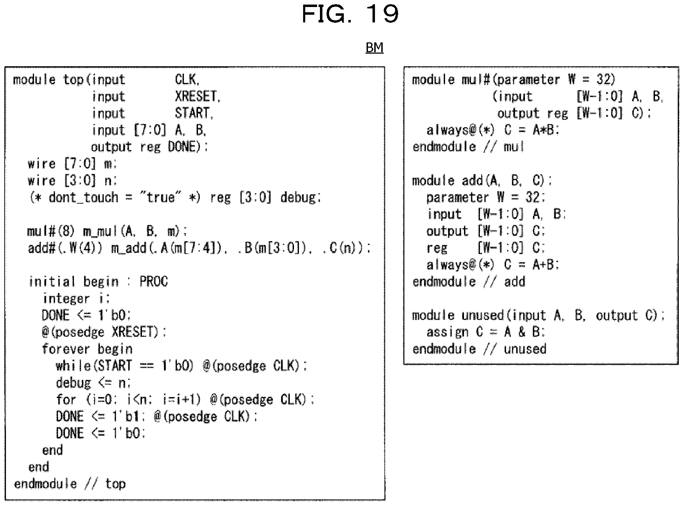

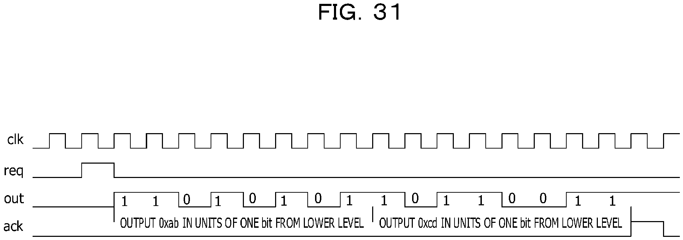

That is, the unused module deletion processing PMR3 generates the syntax tree model STM4 based on information on the syntax tree model STM3 and the analysis information AI. Note that, although an example (first conversion example) of processing to be described with reference to FIGS. 19 to 30 and another example (second conversion example) of processing to be described with reference to FIGS. 31 to 38 will be described later, determination processing for an unused module in the first conversion example will be described here. That is, the module information in the first conversion example is as illustrated in FIG. 13 and, in FIG. 13, only information necessary for the processing of the first conversion example is described out of the module information. Specifically, the unused module deletion processing PMR3 is performed, for example, according to the following procedure.
(1) Acquire a top module name top from the setting file SF.
(2) Pick out mul and add as modules in which top is instantiated, according to the module information.
(3) Confirm that there is no module in which mul is instantiated, according to the module information.
(4) Confirm that there is no module in which add is instantiated, according to the module information.

Therefore, there are three instantiated modules, namely, top, mul, and add, and an "unused" module is assumed as an unused module because the "unused" module is not instantiated.

In addition, relating to the instance description normalization processing PMR4, for example, Verilog-HDL has multiple description methods for the instance of a module in regard to items of port connection and parameter override. For this reason, the expressions in the syntax tree model STM4 are unified into one format. Specifically, the instance description normalization processing PMR4 is performed, for example, by changing the port connection/parameter override by order to the port connection/parameter override by name. That is, the instance description normalization processing PMR4 generates a syntax tree model STM5 based on information on the syntax tree model STM4 and the analysis information AI.

Here, FIG. 14 illustrates an example of a Verilog-HDL description of the syntax tree model (STM4) before conversion, FIG. 15(a) illustrates module information for this description, and FIG. 15(b) illustrates the syntax tree model STM5 that has been reconstructed (normalized or converted). However, FIG. 15(a) illustrates only items necessary for this conversion out of the module information. As illustrated in FIG. 15(a), in the description of the instantiation of the mul module in top, the port connection/parameter override by order is used. Since it can be seen from the module information that mul has ports of A, B, and C, and a parameter of W, it can be seen that A is connected to port A, B is connected to port B, m is connected to port C, and parameter W is overridden with 8 for m_mul.

In this state, if the description of the instantiation of the mul module is modified (reconstructed) to the port connection/parameter override by name, for example, "mul#(8) m mul(A, B, m);" is rewritten to "mul#(.W(8)) m_mul(.A(A), .B(B), .C(m));". That is, as illustrated in FIG. 15(b), "mul#(8) m_mul(A, B, m);" is deleted (the portion with strike-out line is deleted), and "mul#(.W(8)) m_mul(.A(A), .B(B), .C(m));" is added (the underlined portion is added).

Furthermore, the clock/reset analysis processing PMA5 specifies the clock signal and reset signal of each module. Specifically, the clock/reset analysis processing PMA5 is performed, for example, according to the following procedure.
(1) Specify the clock signal and reset signal of the top module from the clock signal name and reset signal name described in the setting file SF.
(2) When the signals in (1) are connected to ports of a lower module, determine the connected ports as a clock signal and a reset signal.

In addition, the instance description modification processing PMR5 modifies the instance description such that port connection restrictions in SystemC are satisfied. That is, the instance description modification processing PMR5 generates a syntax tree model STM6 based on information on the syntax tree model STM5 and the analysis information AI. Specifically, the instance description modification processing PMR5 is performed, for example, by making a modification such that the type of the port and the type of the signal line connected to the port are adapted into a consistent form. Furthermore, the acquisition processing PMA61 for various definitions (variable/task/function) is performed by scanning the syntax tree model STM6 and acquiring information on variable/task/function. Then, the memory information acquisition processing PMA62 specifies a variable to serve as a memory designated by the setting file SF, meanwhile the signal line access analysis processing PMA63 specifies a signal being read and a signal being written by each process.

Furthermore, the processing PMR6 of converting the assign statement into always@* converts the assign statement into always@*, and the sensitivity list resolution processing PMR7 for always@* converts (modifies) a description (always@* or always@(*)) that does not explicitly indicate the sensitivity list of the always statement into a description that explicitly indicates the sensitivity list. That is, the sensitivity list resolution processing PMR7 for always@* generates a syntax tree model STM8 based on information on the syntax tree model STM7 and the analysis information AI. FIG. 16 is for illustrating the sensitivity list resolution processing PMR7 for always@*, and FIG. 16(a) illustrates a specific exemplary description. FIG. 16(b) illustrates an example of the signal line access information. Additionally, FIG. 16(c) illustrates a modification of the description in FIG. 16(a).

In the description illustrated in FIG. 16(a), the always statement of the mul module is a description that does not explicitly indicate the sensitivity list. In addition, as illustrated in FIG. 16(b), in the signal line access information, always_0 is a name given by a tool to identify a process. According to this signal line access information, it can be seen that signals being read by the always statement of the mul module are A and B. In this state, if the always statement is modified to a description that explicitly indicates the sensitivity list, the description as illustrated in FIG. 16(c) is obtained. That is, as is clear from the comparison between FIGS. 16(a) and 16(c), "always@(*) C = A*B;" is modified to "always@(A or B) C = A*B;".

In addition, the high-level synthesis tool-specific conversion processing PMR8 converts (modifies) the syntax tree model STM8 to generate a syntax tree model STM9 (finalized syntax tree model STMf) such that the syntax tree model STM9 is compatible with the target high-level synthesis tool. That is, the high-level synthesis tool-specific conversion processing PMR8 generates the finalized syntax tree model STMf based on information on the syntax tree model STM8, the analysis information AI, and information in the setting file SF. Note that, although a variety of conversions are conceivable depending on the target high-level synthesis tool, an example of modification to avoid "prohibition of reading from output signal (sc_out in System C)", which is a restriction in some high-level synthesis tools, will be indicated as an example. That is, FIGS. 17 and 18 are for illustrating the high-level synthesis tool-specific conversion processing PMR8, and illustrate an example of avoiding "prohibition of reading from output signal (sc_out in System C)".

Here, FIG. 17(a) illustrates a syntax tree model (STM8) before modification, and FIGS. 17(b) and 17(c) illustrate the signal line access information and the variable information; additionally, FIG. 18 illustrates a syntax tree model (STM9 (finalized syntax tree model STMf)) after modification. Note that FIG. 17(a) (FIG. 18) includes a description for reading from the output signal and, in this example, reading from an output signal C is performed in "C <= C+ A;". Next, a specific procedure of the high-level synthesis tool-specific conversion processing PMR8 will be indicated.
(1) Specify an output signal being read. Note that signals being read are A and C according to the signal line access information, and A is excluded because A has input according to the variable information, while C is treated as a target because C has output.
(2) Introduce an intermediate variable (in this example, tmpC) to change read/write to C to read/write to the intermediate variable, and add an always statement for writing tmpC to C. That is, the description (syntax tree model (STM8)) illustrated in FIG. 17(a) is modified to the description (syntax tree model STM9 (STMf)) illustrated in FIG. 18.

Furthermore, the check processing PMAf for high-level synthesis checks whether the description is a high-level synthesizable description. Specifically, the check processing PMAf for high-level synthesis performs a variety of checks such as whether the initial statement is in a designated format, whether there is no missing sensitivity list in the always statement, whether no indeterminate value is used, and whether no memory is accessed from a combinational circuit always.

Then, the SystemC generation processing PSCG generates a SystemC code while scanning the syntax tree model STM9 (finalized syntax tree model STMf). Here, in the SystemC generation processing PSCG, since the syntax tree has been converted such that the SystemC code can be easily generated, the generation processing for the SystemC code can be performed by a plain operation. That is, the SystemC generation processing PSCG generates the SystemC model SCM based on information on the finalized syntax tree model STMf and the analysis information. Note that the synthesis script generation processing PSSG generates a synthesis script SS for high-level synthesis based on the finalized syntax tree model STMf and the information (data) of the setting file SF.

The SystemC model SMC thus obtained can be converted into a logic synthesizable RTL model, for example, by applying a high-level synthesis tool, and can be converted into a netlist by applying a logic synthesis tool to the converted RTL model. That is, according to the SystemC model generation method of the present embodiment, it is possible to apply the HDL behavioral model to logic circuit design.

Hereinafter, two examples of processing of generating a SystemC model from an HDL behavioral model by applying one example of the SystemC model generation method described above will be described with reference to FIGS. 19 to 30 and FIGS. 31 to 38. That is, FIGS. 19 to 30 are diagrams for illustrating an example of processing of generating a SystemC model from an HDL behavioral model by applying the SystemC model generation method illustrated in FIGS. 8 and 9. Note that the processing contents exemplified in FIGS. 19 to 30 (as well as FIGS. 31 to 38) do not have special meanings but are merely examples.

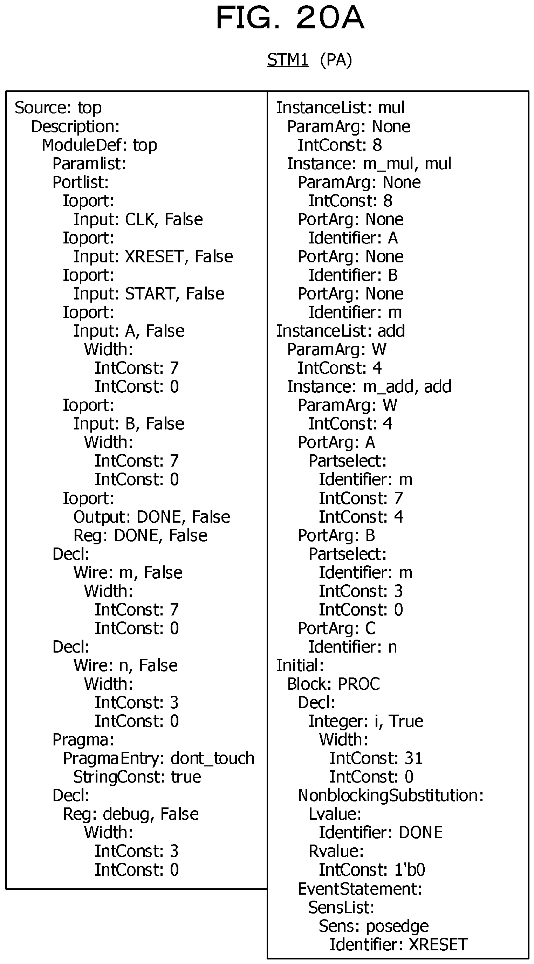

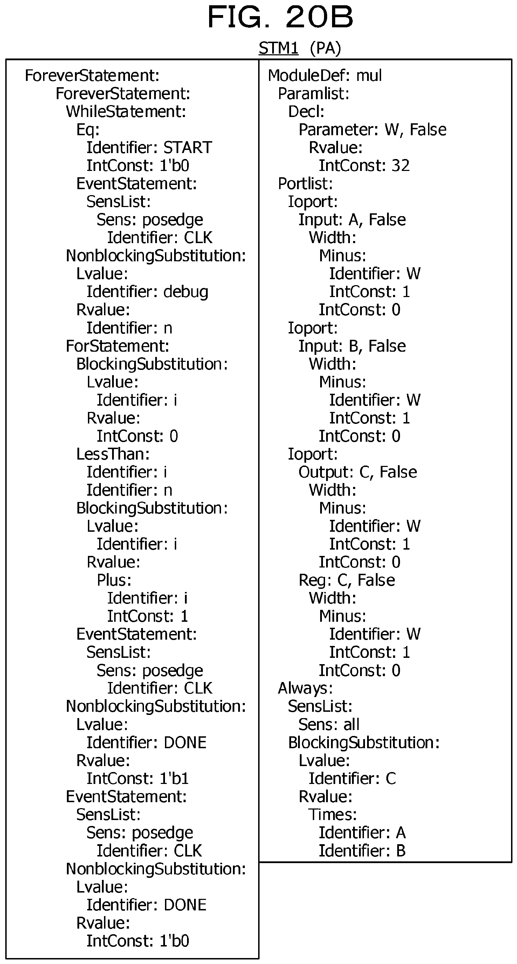

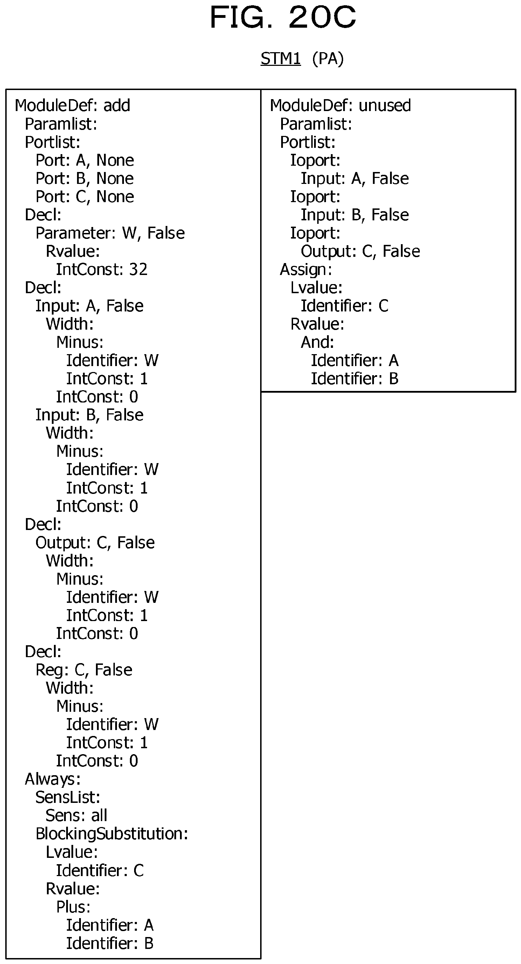

FIG. 19 illustrates an example of the HDL behavioral model BM, and FIG. 20 illustrates the syntax tree model STM1 after conversion (generation or model reconstruction) by performing the lexical analysis/syntax analysis processing PA on the HDL behavioral model BM illustrated in FIG. 19. That is, it can be seen that the HDL behavioral model BM illustrated in FIG. 19 is converted (generated) into the syntax tree model STM1 as in FIG. 20 by performing the above-described lexical analysis/syntax analysis processing PA.

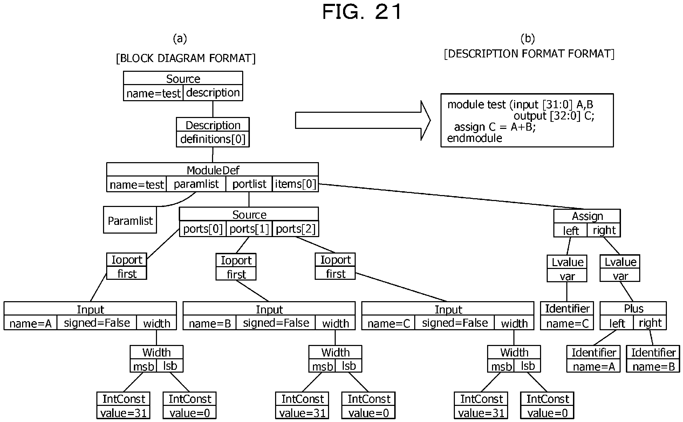

FIG. 21 illustrates an example of the syntax tree model; FIG. 21(a) is represented in a block diagram format, and FIG. 21(b) is represented in a description format (Verilog-HDL: text). That is, the syntax tree model in the block diagram format illustrated in FIG. 21(a) can be illustrated in the description format in FIG. 21(b), and the two diagrams represent the same. Note that, in the present description, the syntax tree model is described in the form of text in order to facilitate understanding; however, it goes without saying that the syntax tree model can also be expressed using the block diagram format or another description format or the like.

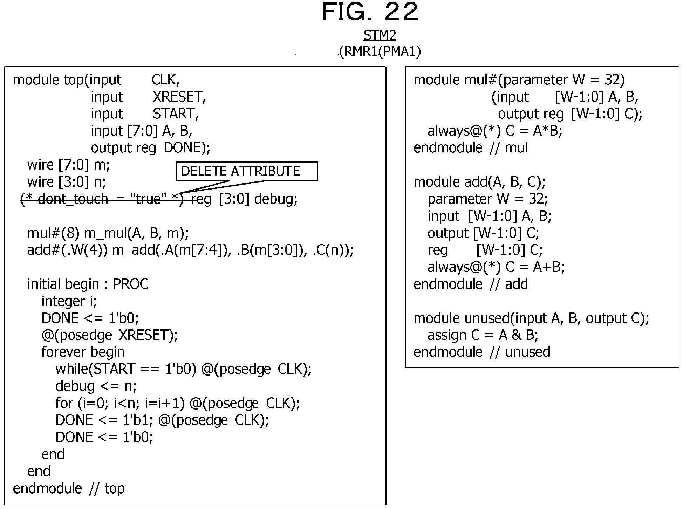

FIG. 22 is for illustrating the attribute acquisition & node deletion processing PMR1 (PMA1), and illustrates the syntax tree model STM2. Note that the deletion of the attribute is similar to that described with reference to FIGS. 12(a) and 12(b). That is, it can be seen in FIG. 22 that, similarly to FIG. 12(b) described above, "(* dont_touch = "true" *)" is deleted by the attribute acquisition & node deletion processing PMR1, and the syntax tree model STM2 is generated.

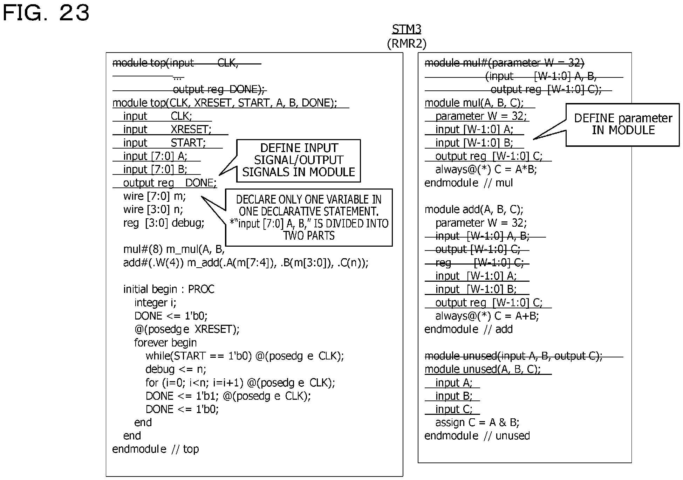

FIG. 23 is for illustrating the module definition normalization processing PMR2, and illustrates the syntax tree model STM3. That is, it can be seen in FIG. 23 that the expressions on the syntax tree model (STM2) are merged into one format by the module definition normalization processing PMR2, and the syntax tree model STM3 is generated. Here, the input signal and the output signal are defined in the module ("module top (input ... output reg DONE);" of STM2 is converted into "module top(CLK, XRESET, START, A, B, DONE); ... output reg DONE;" in STM3), and only one variable is declared in one declarative statement ("input [7:0] A, B," of STM2 is divided into two parts, namely, "input [7:0] A;" and "input [7:0] B;" in STM3). Furthermore, the parameter (parameter) is defined in the module ("module mul#(parameter W = 32) ... output reg [W-1:0] C;" of STM2 is converted into "module mul(A, B, C); ... output reg [W-1:0] C;" in STM3).

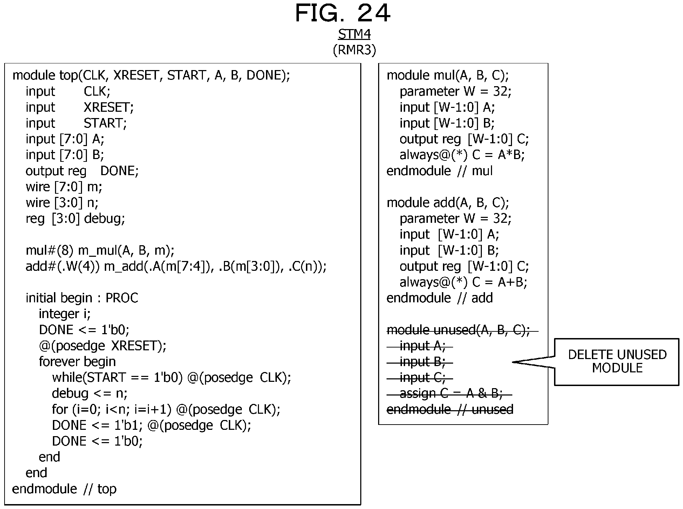

FIG. 24 is for illustrating the unused module deletion processing PMR3, and illustrates the syntax tree model STM4. That is, it can be seen in FIG. 24 that an uninstantiated module definition is deleted from the syntax tree model STM3 by the unused module deletion processing PMR3, and the syntax tree model STM4 is generated. Specifically, "module unused(A, B, C); ... endmodule // unused" of the syntax tree model STM3 is deleted, and the syntax tree model STM4 is generated.

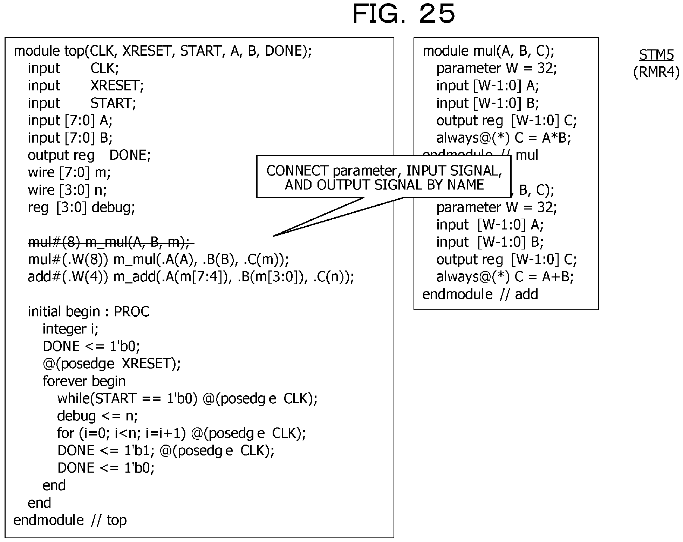

FIG. 25 is for illustrating the instance description normalization processing PMR4, and illustrates the syntax tree model STM5. Here, the instance description normalization processing PMR4 is as described with reference to FIGS. 14 and 15, and FIG. 25 corresponds to FIG. 15(b) described above. That is, as illustrated in FIG. 25, by performing the instance description normalization processing PMR4, parameter, the input signal, and the output signal are connected by name, and "mul#(8) m_mul(A, B, m);" of STM4 is converted into "mul#(.W(8)) m_mul(.A(A), .B(B), .C(m));". Thereafter, STM5 is generated.

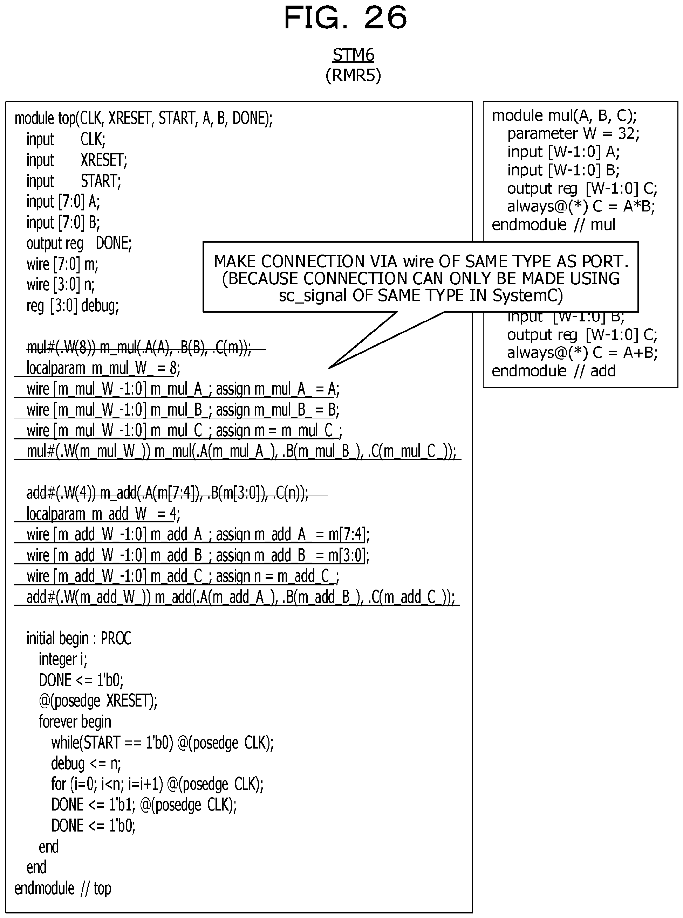

FIG. 26 is for illustrating the instance description modification processing PMR5, and illustrates the syntax tree model STM6. Here, in SystemC, since connection can only be made using sc_signal of the same type, connection is made via wire of the same type as the port. That is, "mul#(.W(8)) m_mul(.A(A), .B(B), .C(m));" and "add#(.W(4)) m_add(.A(m[7:4]), .B(m[3:0]), .C(n));" of STM5 are converted into "localparam m_mul_W_ = 8; ... mul#(.W(m_mul_W_)) m_mul(.A(m_mul_A_), .B(m_mul_B_), .C(m_mul_C_));" and "localparam m_add_W_ = 4; ... add#(.W(m_add_W_)) m_add(.A(m_add_A_), .B(m_add_B_), .C(m_add_C_));", respectively, and STM6 is generated.

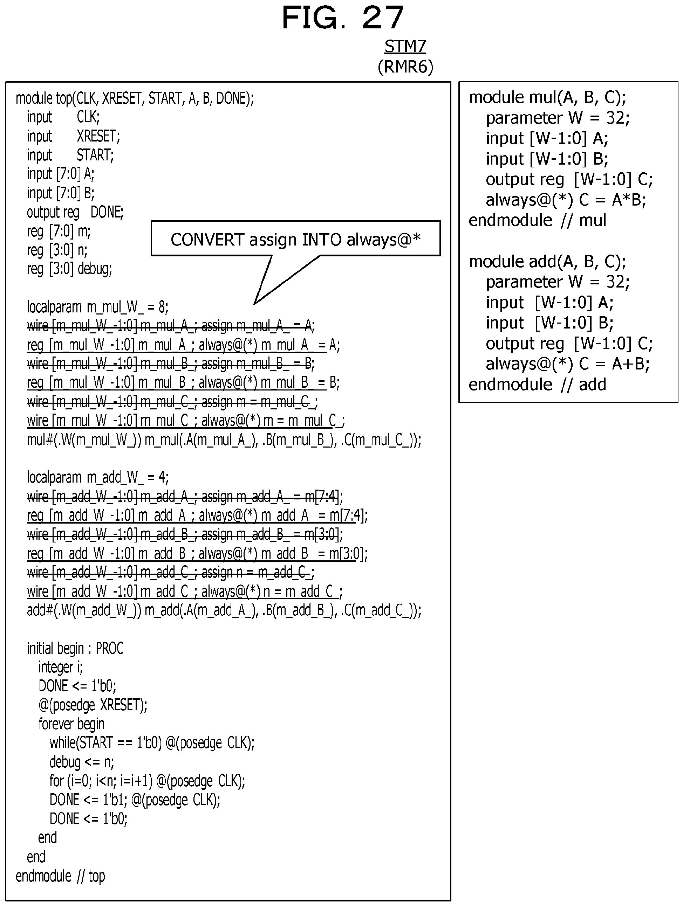

FIG. 27 is for illustrating the processing PMR6 of converting the assign statement into always@*, and illustrates the syntax tree model STM7. That is, the processing PMR6 of converting the assign statement into always@* converts the assign statement into always@*. Specifically, "wire [m_mul_W_-1:0] m_mul_A_; assign m_mul_A_ = A;" and "wire [m_add_W_-1:0] m_add_A_; assign m_add_A_ = m[7:4];" of STM6 are converted into "reg [m_mul_W_-1:0] m_mul_A_; always@(*) m_mul_A_ = A;... wire [m_mul_W_-1:0] m_mul_C_; always@(*) m = m_mul_C_;" and "reg [m_add_W_-1:0] m_add_A_; always@(*) m_add_A_ = m[7:4]; ... wire [m_add_W_-1:0] m_add_C_; always@(*) n = m_add_C_;", respectively, and STM7 is generated.

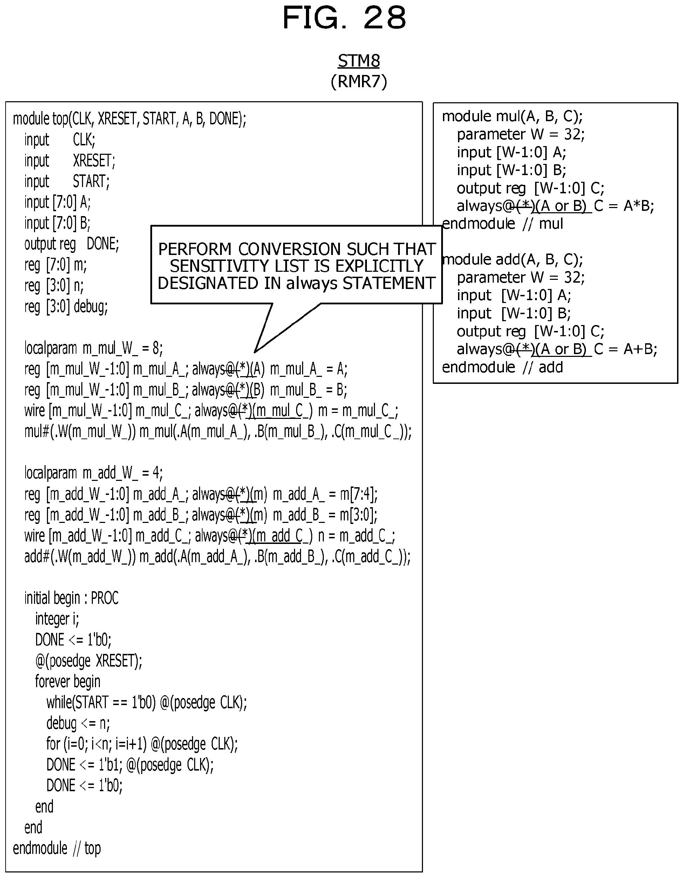

FIG. 28 is for illustrating the sensitivity list resolution processing PMR7 for always@*, and illustrates the syntax tree model STM8. Here, the sensitivity list resolution processing PMR7 for always@* converts a description (always@* or always@(*)) that does not explicitly indicate the sensitivity list of the always statement into a description that explicitly indicates the sensitivity list. That is, for example, descriptions of STM6 such as "reg [m_mul_W_-1:0] m_mul_A_; always@(*) m_mul_A_ = A;" and "always@(*) C = A*B;" are converted into descriptions such as "reg [m_mul_W_-1:0] m_mul_A_; always@(A) m_mul_A_ = A;" and "always@(A or B) C = A*B;", and STM8 is generated. Note that part of FIG. 28 corresponds to FIG. 16(c) described above. In addition, the high-level synthesis tool-specific conversion processing PMR8 has, for example, a description that is not synthesizable depending on the high-level synthesis tool; accordingly, the syntax tree model STM8 is processed so as to be synthesizable, and the syntax tree model STM9 (finalized syntax tree model STMf) is generated. However, the description thereof is omitted here.

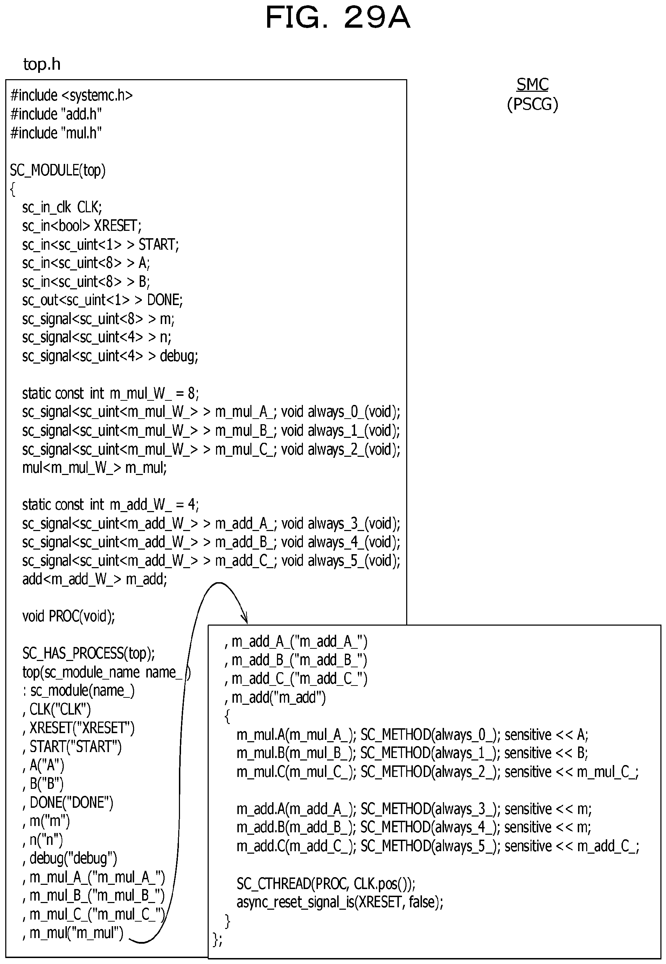

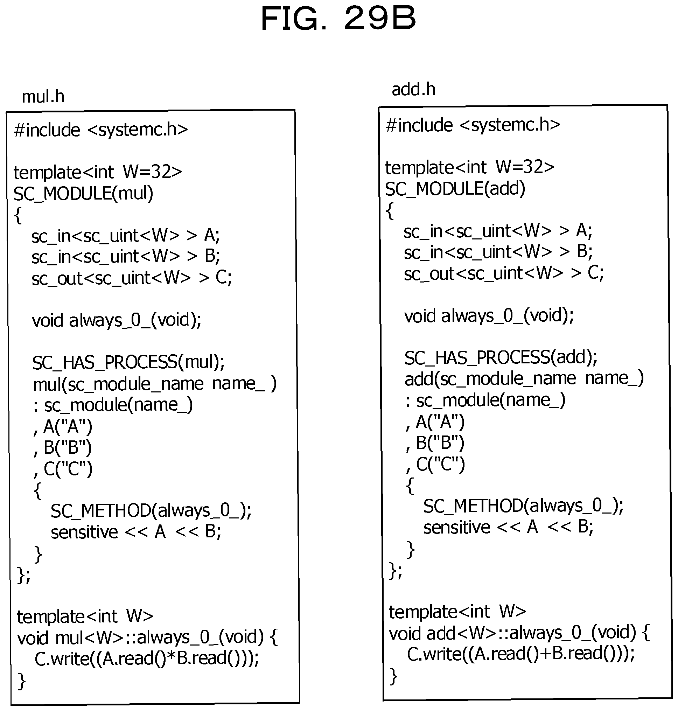

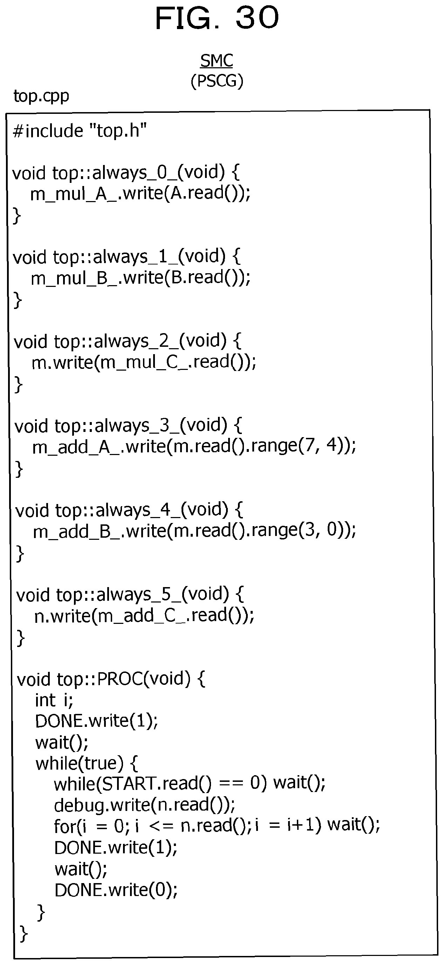

FIGS. 29 and 30 are for illustrating the SystemC generation processing PSCG, and illustrate the SystemC model SMC. Here, FIG. 29 illustrates a header file of the SystemC model SMC, and FIG. 30 illustrates a source file of the SystemC model SMC. As described above, it can be seen that the SystemC model SMC as illustrated in FIGS. 29 and 30 can be generated by applying the SystemC model generation method illustrated in FIGS. 8 and 9 to the HDL behavioral model BM illustrated in FIG. 19. Note that, as described above, the SystemC model SMC thus obtained can generate a logic synthesizable RTL model (can be converted into an RTL model), for example, by applying a high-level synthesis tool, and can be converted into a netlist (3) by applying a logic synthesis tool (2) to the converted RTL model (1).

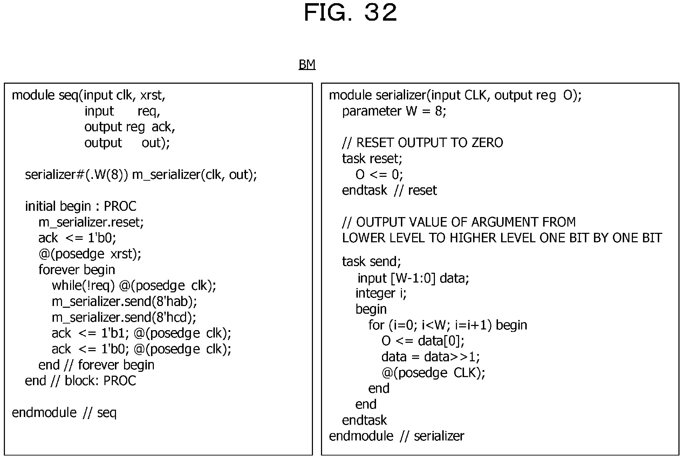

Next, another example of processing of generating a SystemC model from an HDL behavioral model will be described with reference to FIGS. 31 to 38. FIG. 31 illustrates an example of sequence processing, and illustrates sequence processing that outputs 2-byte (16-bit) data 0xab and 0xcd in units of one bit from a time of each byte when receiving a request signal req, and returns an acknowledge signal ack upon finishing. FIG. 32 illustrates an example of the HDL behavioral model BM corresponding to the sequence processing illustrated in FIG. 31.

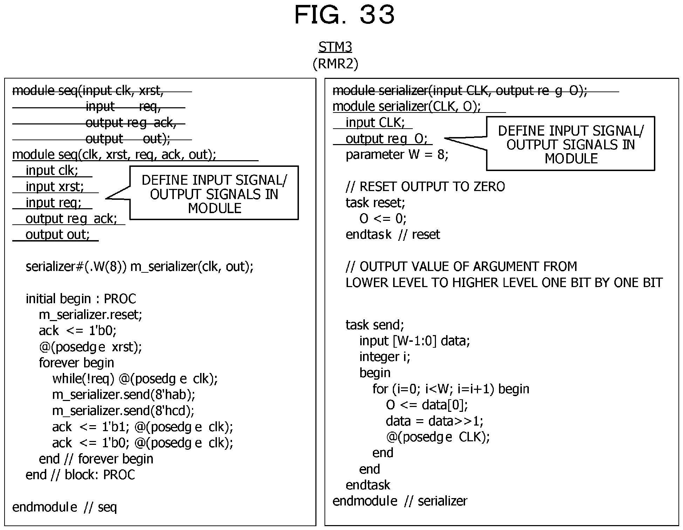

First, the attribute acquisition & node deletion processing PMR1 (PMA1) is performed; however, in the HDL behavioral model BM illustrated in FIG. 32, the syntax tree model is not altered even if the attribute deletion processing is performed. That is, the syntax tree model STM2 is the same as the syntax tree model STM1. FIG. 33 is for illustrating the module definition normalization processing PMR2, and illustrates the syntax tree model STM3. That is, it can be seen in FIG. 33 that the expressions on the syntax tree model (STM2) are merged into one format by the module definition normalization processing PMR2, and the syntax tree model STM3 is generated. Here, the input signal and the output signal are defined in the module ("module seq(input clk, xrst, ... output out);" and "module serializer(input CLK, output reg O);" of STM2 are converted into "module seq(clk, xrst, req, ack, out); ... output out;" and "module serializer(CLK, O); ... output reg O;", respectively, in STM3. Note that the syntax tree model is not altered even if the unused module deletion processing PMR3 is performed, and the syntax tree model STM4 is the same as the syntax tree model STM3.

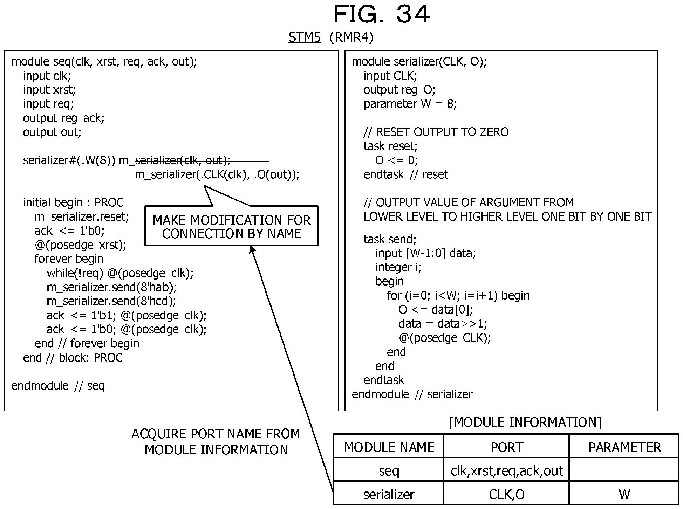

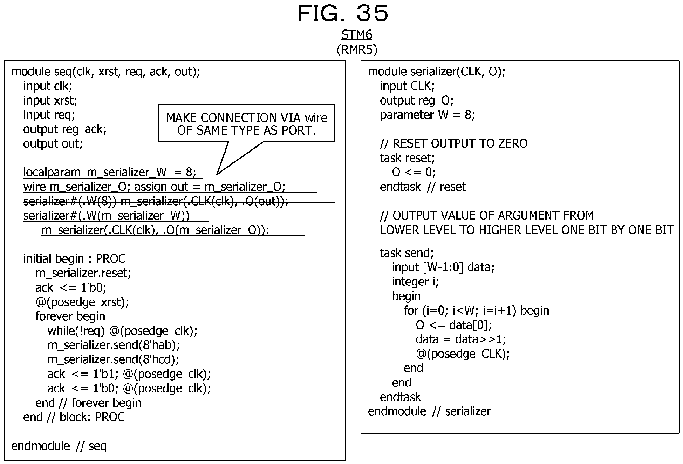

FIG. 34 is for illustrating the instance description normalization processing PMR4, and illustrates the syntax tree model STM5. Here, for example, the instance description normalization processing PMR4 acquires the port name from the module information, and makes a modification for connection by name. That is, as illustrated in FIG. 34, "m_serializer(clk, out);" of STM4 (STM3) is converted into "m_serializer(.CLK(clk), .O(out));", and STM5 is generated. In addition, FIG. 35 is for illustrating the instance description modification processing PMR5, and illustrates the syntax tree model STM6. Here, in order to make a connection via wire of the same type as the port, "serializer#(.W(8)) m_serializer(.CLK(clk), .O(out));" of STM5 is converted into "localparam m_serializer_W = 8;... m_serializer(.CLK(clk), .O(m_serializer_O));", and STM6 is generated.

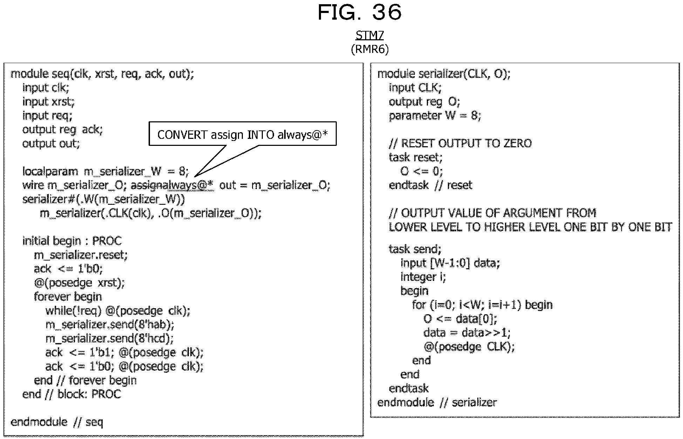

FIG. 36 is for illustrating the processing PMR6 of converting the assign statement into always@*, and illustrates the syntax tree model STM7. That is, the processing PMR6 of converting the assign statement into always@* converts the assign statement into always@*. Specifically, "assign out = m_serializer_O;" of STM6 is converted into "always@* out = m_serializer_O;", and STM7 is generated.

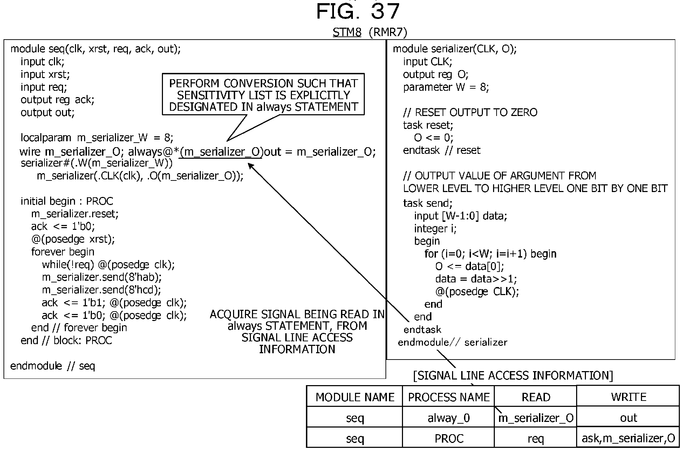

FIG. 37 is for illustrating the sensitivity list resolution processing PMR7 for always@*, and illustrates the syntax tree model STM8. Here, the sensitivity list resolution processing PMR7 for always@* performs conversion such that the sensitivity list is explicitly designated in the always statement. Specifically, "always@* out = m_serializer_0;" of STM6 is converted into "always@(m_serializer_O) out = m_serializer_O;", and STM8 is generated. Note that the signal being read in the always statement can be acquired from, for example, the signal line access information. In addition, the syntax tree model is not altered even if the high-level synthesis tool-specific conversion processing PMR8 is performed, and the syntax tree model STM9 (finalized syntax tree model STMf) is the same as the syntax tree model STM8.

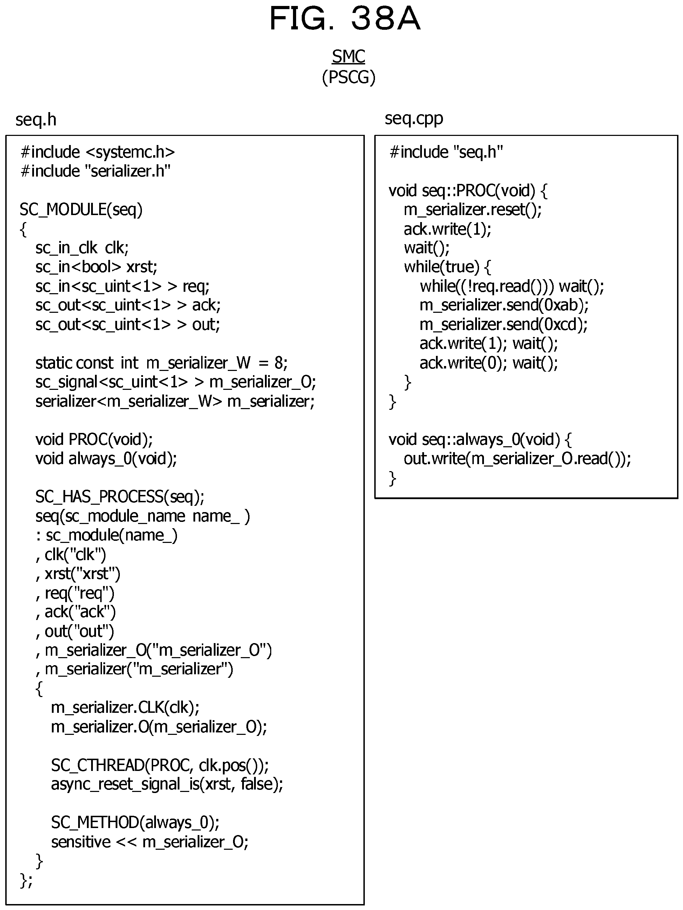

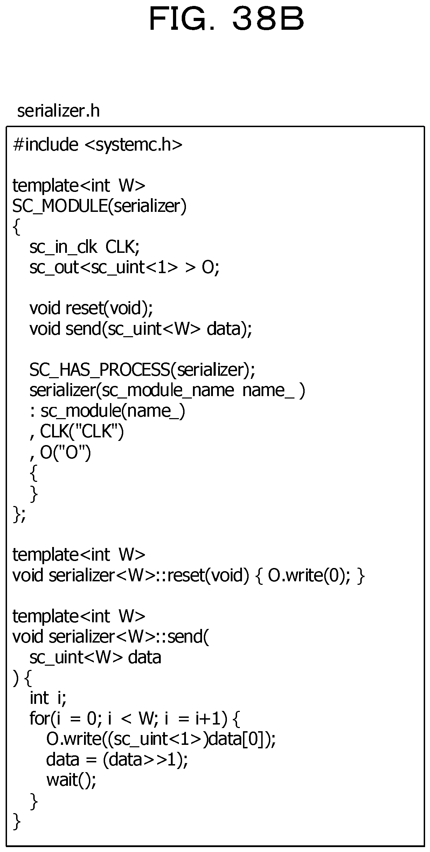

FIG. 38 is for illustrating the SystemC generation processing PSCG, and illustrates the SystemC model SMC. As described above, it can be seen that the SystemC model SMC as illustrated in FIG. 38 can be generated by applying the SystemC model generation method illustrated in FIGS. 8 and 9 to the HDL behavioral model BM illustrated in FIG. 32. Here, the obtained SystemC model SMC can be converted into a logic synthesizable RTL model, for example, by applying a high-level synthesis tool, and can be converted into a netlist by applying a logic synthesis tool to the converted RTL model. Note that the conversion examples described above with reference to FIGS. 19 to 30 and FIGS. 31 to 38 are merely examples, and the SystemC model generation method of the present embodiment can be applied widely to a variety of HDL behavioral models BM. Furthermore, the present embodiment can also be provided as the SystemC model generation program to be executed on an OS of a computer, such as Linux (registered trademark) or Windows (registered trademark).

While the embodiments have been described thus far, all the examples and conditions described herein are for the purpose of assisting the understanding of the concept of the invention applied to the invention and the technology and, in particular, the described examples and conditions are not intended to limit the scope of the invention. In addition, such descriptions in the description do not indicate the advantages and disadvantages of the invention. While the embodiments of the invention have been described in detail, it should be understood that various changes, substitutions, and alterations can be made without departing from the spirit and scope of the invention.

Regarding the above-described embodiments including the examples, the following notes will be further disclosed.

### (Note 1)

A SystemC model generation method of generating a SystemC model capable of high-level synthesis from a hardware description language (HDL) behavioral model designed with an HDL simulation syntax,
the SystemC model generation method including:
analyzing the HDL behavioral model to generate a syntax tree model;
analyzing the syntax tree model to extract analysis information; and
reconstructing the syntax tree model based on the syntax tree model and the analysis information to generate the SystemC model.

### (Note 2)

The SystemC model generation method according to note 1, in which
the analyzing the HDL behavioral model to generate the syntax tree model is performed by analyzing a lexical and a syntax of the HDL behavioral model.

### (Note 3)

The SystemC model generation method according to note 1 or 2, in which
the reconstructing the syntax tree model based on the syntax tree model and the analysis information:
extracts different pieces of the analysis information from the syntax tree model according to an order based on dependency between respective items of processing; and
performs different types of reconstruction of the syntax tree model based on the different pieces of the analysis information, to generate a finalized syntax tree model.

### (Note 4)

The SystemC model generation method according to note 3, further including:
analyzing the finalized syntax tree model to extract finalized analysis information; and
generating the SystemC model based on the finalized syntax tree model and the finalized analysis information.

### (Note 5)

The SystemC model generation method according to any one of notes 1 to 4, in which
the reconstructing the syntax tree model based on the syntax tree model and the analysis information includes:
unused module deletion processing of deleting uninstantiated module definition from a syntax tree;
instance description normalization processing of adapting a format of an instance of a submodule into a consistent form;
instance description modification processing of changing an instance description of the submodule;
sensitivity list resolution processing for always@* of converting an assign statement into always@*; or
high-level synthesis tool-specific conversion processing of performing high-level synthesis tool-specific conversion; or any combination thereof.

### (Note 6)

The SystemC model generation method according to note 5, in which
the unused module deletion processing
refers to module definition information when specifying an unused module, and thus depends on module definition analysis processing and the syntax tree model.

### (Note 7)

The SystemC model generation method according to note 5, in which
the instance description normalization processing
refers to module definition information when converting a connection by order into a connection by name, and thus depends on module definition analysis processing and the syntax tree model.

### (Note 8)

The SystemC model generation method according to note 5, in which
the instance description modification processing
modifies an instance description such that a connection of a clock signal and a reset signal is connected in a different manner from another connection, and thus depends on clock/reset analysis processing and the syntax tree model.

### (Note 9)

The SystemC model generation method according to note 5, in which
the sensitivity list resolution processing
uses information as to which signal line each process is accessing when deriving a sensitivity list, while an always statement is added, and thus depends on processing of converting an assign statement into always@*, signal line access analysis processing, and the syntax tree model.

### (Note 10)

The SystemC model generation method according to note 5, in which
the high-level synthesis tool-specific conversion processing
carries out high-level synthesis tool-specific conversion with a finalized syntax tree model, and thus depends on the sensitivity list resolution processing for always@* and the syntax tree model.

### (Note 11)

The SystemC model generation method according to any one of notes 1 to 10, in which
the high-level synthesis generates a logic synthesizable register transfer level (RTL) from the SystemC model using a high-level synthesis tool, and
the high-level synthesis applies a logic synthesis tool to the generated RTL to convert the generated RTL into a netlist.

### (Note 12)

The SystemC model generation method according to any one of notes 1 to 11, in which
the HDL behavioral model is Verilog-HDL or VHDL.

### (Note 13)

A SystemC model generation program that generates a SystemC model capable of high-level synthesis from an HDL behavioral model designed with an HDL simulation syntax,
the SystemC model generation program causing a computer to execute:
processing of analyzing the HDL behavioral model to generate a syntax tree model;
processing of analyzing the syntax tree model to extract analysis information; and
processing of reconstructing the syntax tree model based on the syntax tree model and the analysis information to generate the SystemC model.

### (Note 14)

The SystemC model generation program according to note 13, in which
the processing of reconstructing the syntax tree model based on the syntax tree model and the analysis information includes:
processing of extracting different pieces of the analysis information from the syntax tree model according to an order based on dependency between respective items of processing; and
processing of performing different types of reconstruction of the syntax tree model based on the different pieces of the analysis information, to generate a finalized syntax tree model.

### (Note 15)

The SystemC model generation program according to note 14, further causing
the computer to execute:
processing of analyzing the finalized syntax tree model to extract finalized analysis information; and
processing of generating the SystemC model based on the finalized syntax tree model and the finalized analysis information.

### (Note 16)

The SystemC model generation program according to any one of notes 13 to 15, in which
the processing of reconstructing the syntax tree model based on the syntax tree model and the analysis information includes:
unused module deletion processing of deleting uninstantiated module definition from a syntax tree;
instance description normalization processing of adapting a format of an instance of a submodule into a consistent form;
instance description modification processing of changing an instance description of the submodule;
sensitivity list resolution processing for always@* of converting an assign statement into always@*; or
high-level synthesis tool-specific conversion processing of performing high-level synthesis tool-specific conversion; or any combination thereof.

### REFERENCE SIGNS LIST

1 RTL model
2 logic synthesis tool
3 netlist (gate circuit)
4 behavioral model
40, BM HDL behavioral model
41 SystemC model generation unit
42, SCM SystemC model
43, SS synthesis script
44 high-level synthesis tool
AI analysis information
PMA01, PMA02, PMA3, PMA5, PMA6, PMA61, PMA63 model analysis processing
PMAf check processing for high-level synthesis
PMR01, PMR02, PMR1 to PMR8 model reconstruction processing
PSCG SystemC generation processing
PSSG synthesis script generation processing
SF setting file
STM01 to STM03, STM1 to STM9 syntax tree model
STMf finalized syntax tree model

## Claims

1. A SystemC model generation method of generating a SystemC model capable of high-level synthesis from a hardware description language (HDL) behavioral model designed with an HDL simulation syntax, the SystemC model generation method comprising:
analyzing the HDL behavioral model to generate a syntax tree model;
analyzing the syntax tree model to extract analysis information; and
reconstructing the syntax tree model based on the syntax tree model and the analysis information to generate the SystemC model.

2. The SystemC model generation method according to claim 1, wherein
the analyzing the HDL behavioral model to generate the syntax tree model is
performed by analyzing a lexical and a syntax of the HDL behavioral model.

3. The SystemC model generation method according to claim 1 or 2, wherein
the reconstructing the syntax tree model based on the syntax tree model and the analysis information:
extracts different pieces of the analysis information from the syntax tree model according to an order based on dependency between respective items of processing; and
performs different types of reconstruction of the syntax tree model based on the different pieces of the analysis information, to generate a finalized syntax tree model.

4. The SystemC model generation method according to claim 3, further comprising:
analyzing the finalized syntax tree model to extract finalized analysis information; and
generating the SystemC model based on the finalized syntax tree model and the finalized analysis information.

5. The SystemC model generation method according to any one of claims 1 to 4, wherein
the reconstructing the syntax tree model based on the syntax tree model and the analysis information includes:
unused module deletion processing of deleting uninstantiated module definition from a syntax tree;
instance description normalization processing of adapting a format of an instance of a submodule into a consistent form;
instance description modification processing of changing an instance description of the submodule;
sensitivity list resolution processing for always@* of converting an assign statement into always@*; or
high-level synthesis tool-specific conversion processing of performing high-level synthesis tool-specific conversion; or any combination thereof.

6. The SystemC model generation method according to claim 5, wherein
the unused module deletion processing
refers to module definition information when specifying an unused module, and thus depends on module definition analysis processing and the syntax tree model.

7. The SystemC model generation method according to claim 5, wherein
the instance description normalization processing
refers to module definition information when converting a connection by order into a connection by name, and thus depends on module definition analysis processing and the syntax tree model.

8. The SystemC model generation method according to claim 5, wherein
the instance description modification processing
modifies an instance description such that a connection of a clock signal and a reset signal is connected in a different manner from another connection, and thus depends on clock/reset analysis processing and the syntax tree model.

9. The SystemC model generation method according to claim 5, wherein
the sensitivity list resolution processing
uses information as to which signal line each process is accessing when deriving a sensitivity list, while an always statement is added, and thus depends on processing of converting an assign statement into always@*, signal line access analysis processing, and the syntax tree model.

10. The SystemC model generation method according to claim 5, wherein
the high-level synthesis tool-specific conversion processing
carries out high-level synthesis tool-specific conversion with a finalized syntax tree model, and thus depends on the sensitivity list resolution processing for always@* and the syntax tree model.

11. The SystemC model generation method according to any one of claims 1 to 10, wherein
the high-level synthesis generates a logic synthesizable register transfer level (RTL) from the SystemC model using a high-level synthesis tool, and
the high-level synthesis applies a logic synthesis tool to the generated RTL to convert the generated RTL into a netlist.

12. The SystemC model generation method according to any one of claims 1 to 11, wherein
the HDL behavioral model is Verilog-HDL or VHDL.

13. A SystemC model generation program that generates a SystemC model capable of high-level synthesis from an HDL behavioral model designed with an HDL simulation syntax, the SystemC model generation program causing a computer to execute:
processing of analyzing the HDL behavioral model to generate a syntax tree model;
processing of analyzing the syntax tree model to extract analysis information; and
processing of reconstructing the syntax tree model based on the syntax tree model and the analysis information to generate the SystemC model.

14. The SystemC model generation program according to claim 13, wherein
the processing of reconstructing the syntax tree model based on the syntax tree model and the analysis information includes:
processing of extracting different pieces of the analysis information from the syntax tree model according to an order based on dependency between respective items of processing; and
processing of performing different types of reconstruction of the syntax tree model based on the different pieces of the analysis information, to generate a finalized syntax tree model.

15. The SystemC model generation program according to claim 14, further causing
the computer to execute:
processing of analyzing the finalized syntax tree model to extract finalized analysis information; and
processing of generating the SystemC model based on the finalized syntax tree model and the finalized analysis information.

16. The SystemC model generation program according to any one of claims 13 to 15, wherein
the processing of reconstructing the syntax tree model based on the syntax tree model and the analysis information includes:
unused module deletion processing of deleting uninstantiated module definition from a syntax tree;
instance description normalization processing of adapting a format of an instance of a submodule into a consistent form;
instance description modification processing of changing an instance description of the submodule;
sensitivity list resolution processing for always@* of converting an assign statement into always@*; or
high-level synthesis tool-specific conversion processing of performing high-level synthesis tool-specific conversion; or any combination thereof.
